(19) Europäisches Patentamt
European Patent Office
Office européen des brevets

(11) EP 2 246 897 A2

# (12) EUROPEAN PATENT APPLICATION

(43) Date of publication:
**03.11.2010 Bulletin 2010/44**

(21) Application number: **10161609.2**

(22) Date of filing: **30.04.2010**

(51) Int Cl.:
***H01L 31/0336*** *(2006.01)* ***H01L 31/072*** *(2006.01)*
***H01L 31/18*** *(2006.01)*

(84) Designated Contracting States:
**AT BE BG CH CY CZ DE DK EE ES FI FR GB GR HR HU IE IS IT LI LT LU LV MC MK MT NL NO PL PT RO SE SI SK SM TR**
Designated Extension States:
**AL BA ME RS**

(30) Priority: **01.05.2009 JP 2009112203**
**11.09.2009 JP 2009209939**

(71) Applicant: **FUJIFILM Corporation**
**Minato-ku**
**Tokyo (JP)**

(72) Inventors:
- **Kawano, Tetsuo**
  **Ashigarakami-gun,**
  **Kanagawa-ken (JP)**
- **Hirai, Hiroyuki**
  **Ashigarakami-gun, Kanagawa-ken (JP)**
- **Suzuki, Masayuki**
  **Ashigarakami-gun, Kanagawa-ken (JP)**

(74) Representative: **Klunker . Schmitt-Nilson . Hirsch**
**Patentanwälte**
**Destouchesstrasse 68**
**80796 München (DE)**

## (54) Layered film and manufacturing method thereof, photoelectric conversion device and manufacturing method thereof, and solar cell apparatus

(57) Providing a technology for forming a metal oxide layer covering an underlayer without any cracks. Using a manufacturing method which includes a process (A) for forming a particle layer of a plurality of one or more types of particles consisting mainly of a metal oxide and/or a metal hydroxide, and a process (B) for forming, using a reaction solution which includes one or more types of metal ions, a metal oxide layer consisting mainly of an oxide of the one or more types of metal ions on the particle layer so as to cover the particle layer without any cracks by a liquid phase method under a pH condition in which at least a portion of the plurality of particles remains without being dissolved by the reaction solution, a layered film having a layered structure of the particle layer and the metal oxide layer is manufactured.

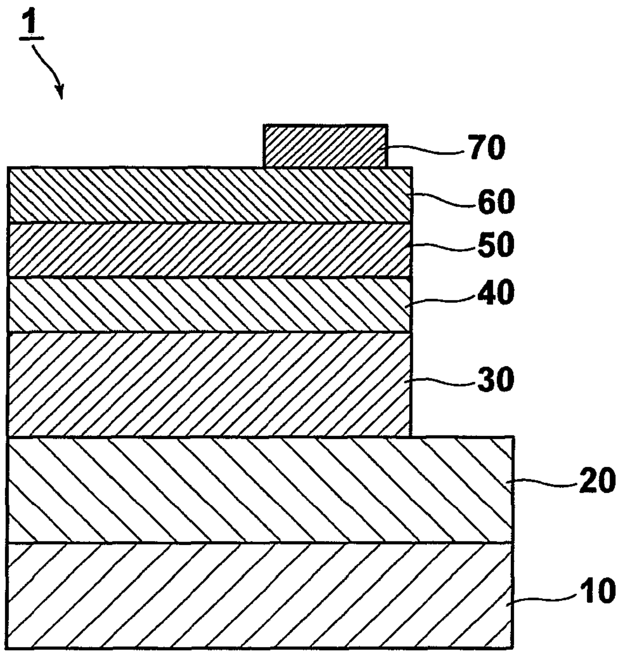


FIG.1

EP 2 246 897 A2

**Description**

BACKGROUND OF THE INVENTION

Field of the Invention

The present invention relates to a layered film having a metal oxide layer and a manufacturing method thereof, a photoelectric conversion device using the layered film and a manufacturing method thereof, and a solar cell apparatus.

Description of the Related Art

Photoelectric conversion devices having a photoelectric conversion layer and electrodes electrically connected to the photoelectric conversion layer are used in various applications, such as solar cells and the like. Most of conventional solar cells are Si-based cells that use bulk monocrystalline Si, polycrystalline Si, or thin film amorphous Si. Recently, however, research and development of compound semiconductor-based solar cells that do not depend on Si has been carried out. Two types of compound semiconductor-based solar cells are known, one of which is a bulk system, such as GaAs system and the like, and the other of which is a thin film system, such as CIS system formed of a group Ib element, a group IIIb element, and a group VIb element, CIGS, or the like. CI (G) S is a compound semiconductor represented by a general formula, $Cu_{1-z}In_{1-x}Ga_xSe_{2-y}S_y$ ($0 \leq x \leq 1$, $0 \leq y \leq 2$, $0 \leq z \leq 1$). The formula represents a CIS system when $x = 0$ and a CIGS system when $x > 0$. Sometimes, CIS and CIGS are, herein, collectively referred to as "CI(G)S".

In conventional thin film photoelectric conversion devices, such as CI(G)S, a CdS buffer layer is typically provided between a photoelectric conversion layer and a light transparent conductive layer (transparent electrode) formed on the photoelectric conversion layer. In such systems, the buffer layer is generally formed by a CBD (chemical bath deposition) method.

The functions of the buffer layer may include (1) prevention of photogenerated carrier recombination (2) band discontinuity alignment (3) lattice matching and (4) compensation for surface unevenness of photoelectric conversion layer. In CI(G)S systems, surface unevenness of photoelectric conversion layers is relatively large, and it can be said that the CBD method, which is a liquid phase method, is preferable in order to satisfy the condition described in (4) above.

In consideration of environmental burden, a Cd-free buffer layer has been studied. As for the composition of the buffer layer, for example, a zinc compound, such as ZnO, is preferably used. When forming a ZnO film by the CBD method, it is important to form a film that favorably covers the underlayer by controlling the crystal growth. But, ZnO is a wurtzite-type crystal and the growth rate in c-axis direction of the crystal is often faster and the crystal is likely to grow in a rod shape unless a shape control agent (organic molecule or the like) that controls the growth of a specific crystal plane is used. Consequently, a large rod-like crystal may be deposited instead of a film or a film structure of a row of multiple rod-like fine crystals with a crack between them may be formed (Comparative Examples 1 to 6 under [Examples] to be described later) .

It is proposed to perform crystal growth of a zinc compound by the CBD method after providing multiple nanoparticles on the underlayer.

Japanese Patent No. 3256776 (Patent Document 1) discloses a zinc oxide film forming composition of an aqueous solution which includes a zinc ion, a nitric acid ion, and a borane-amine complex (claim 1). As for the borane-amine complex, dimethylamine borane, trimethylamine borane, and the like are described in paragraph [0011]. A method of forming a ZnO film is described in paragraph [0023] in which Pd catalyst is provided on a substrate on which the ZnO film is formed and then the substrate is dipped in the composition described above.

Japanese Patent No. 4081625 (Patent Document 2) discloses a method of forming a ZnO film in which an underlayer is catalyzed first by an activator which includes Ag ion and then a ZnO film is formed using a zinc oxide deposition solution (claim 1) . As the zinc oxide deposition solution, a solution which includes zinc nitrate and dimethylamine borane is described in paragraph [0026] . A method of growing a ZnO film is described in paragraph [0026], in which, after catalyzing the underlayer by an activator which includes Ag ion, ZnO is deposited by an electroless method and ZnO is grown by applying a current with the ZnO deposit as the cathode and a zinc plate as the anode in a zinc oxide deposition solution.

Japanese Unexamined Patent Publication No. 2004-006790 (Patent Document 3) discloses a metal oxide pattern forming method for forming a metal oxide pattern by forming a metal particle pattern on a substrate and selectively depositing a metal oxide (claim 1) . A method of forming a ZnO pattern film by forming a Pd particle pattern on a substrate and dipping the substrate in a mixed solution of zinc nitrate and dimethylamine borane is described in paragraphs [0073] and [0074].

Japanese Unexamined Patent Publication No. 2002-170429 (Patent Document 4) discloses a method of forming an electroless zinc oxide film by forming a Pd core dispersion layer on the underlayer and dipping the underlayer in an electroless zinc oxide plating solution which includes a borane reducing agent (claim 5). As the electroless zinc oxide plating solution, a solution which includes a zinc salt, such as zinc nitrate or the like, and an amine borane reducing agent, such as dimethylamine borane or the like, and the like are described in paragraph [0030].

Japanese Unexamined Patent Publication No. 2004-346383 (Patent Document 5) discloses a method of forming a ZnO film in which an underlayer is sensitized using a Sn solution, which is then brought into contact with a solution which includes a silver ion and further brought into contact with an acid solution which includes Pd to activate the underlayer, and underlayer is brought into contact with an aqueous solution which includes a zinc ion, a nitrate ion, and a borane-amine complex (claim 7).

A method of forming a ZnO film using a solution which includes zinc nitrate and dimethylamine borane after providing Sn as a sensitizer and Pd as an activator on an underlayer is described in M. Izaki and T. Omi, "Transparent Zinc Oxide Films Chemically Prepared from Aqueous Solution", Journal of The Electrochemical Society, Vol. 144, No. 1, pp. L3-L4, 1997 (Non-patent Document 1) and H. Ishizaki et al., "Influence of (CH3)2NHBH3 Concentration on Electrical Properties of Electrochemically Grown ZnO Films", Journal of The Electrochemical Society, Vol. 148, No. 8, pp. C540-C543, 2001, (Non-patent Document 2).

Japanese Unexamined Patent Publication No. 2007-242646 (Patent Document 6) discloses a method of forming a buffer layer by providing core particles, of a type which is the same or different from that of the buffer layer, on a photoelectric conversion layer and using the core particles as the starting point or catalyst (claim 1) . As for the method of providing the particles, a redox reaction used in a conventional plating process and a CBD method are described (claims 2 and 3). As for the method of forming the buffer layer, a CBD method is described (claim 6). As for the major component of the particles serving as the core and buffer layer, only ZnS is specifically described (claims 8 and 10).

A literature L.E. Greene et al., "General Route to Vertical ZnO Nanowire Arrays Using Textured ZnO Seeds", Nano Letters, Vol. 5, No. 7, pp. 1231-1236, 2005 (Non-patent Document 3) describes a method in which a ZnO layer obtained by heat treating a zinc acetate layer at 350°C or a ZnO layer obtained by coating a solution which includes ZnO nanocrystals is provided on an underlayer, and a ZnO nanowire film (formed of ZnO crystals having a one dimensional form) is formed on the ZnO layer using a reaction solution which includes zinc nitrate and hexamethylenetetramine (cited from Ref. 27 described in Non-patent Document 3).

In Patent Documents 1 to 5 and Non-patent Documents 1 and 2, ZnO is grown after providing one or more metals, such as Sn, Pd, Ag, and the like, on the underlayer, which is generally practiced in electroless plating. For photoelectric conversion devices, what is required is to form a semiconductor film. Accordingly, provision of a metal having conductivity causes desired semiconductor properties not to be obtained.

Patent Document 6 described a method of growing a buffer layer by a CBD method after providing core particles of a type which is the same as that of the buffer layer. It is described in paragraph [0007] or other sections of Patent Document 6 that a buffer layer that covers a photoelectric conversion layer, which is the underlayer, without any cracks can be formed. Patent Document 6, however, does not specifically describe a buffer layer having a composition other than ZnS. Therefore, Patent Document 6 does not describe any condition for forming a buffer layer covering the underlayer without any cracks using an oxide, such as ZnO or the like. Since different compositions require largely different reaction solutions and reaction conditions, reference to Patent Document 6 does not allow an oxide buffer layer covering the underlayer without any cracks to be formed.

Non-patent Document 3 describes a method in which a ZnO particle layer is formed by heat treating a zinc acetate layer at 350°C (Figure 1b) or a ZnO layer is formed by coating a solution which includes ZnO nanocrystals (Figure 1d) on the underlayer, and then a ZnO is grown. The film formed in Non-patent Document 3 is a ZnO nanowire film (formed of ZnO crystals having a one dimensional form) in which multiple ZnO nanowires extending in a direction perpendicular to the substrate surface are arranged side by side (Figures 2a, 2b, and the like) . Such film structure has a large crack between adjacent nanowires and large surface unevenness, so that such film can not be used as a buffer layer of a photoelectric conversion device.

As described above, there has been no report concerning a method that does not use a metal and forms an oxide buffer layer covering the underlayer without any cracks.

A CBD condition for conventional general CdS buffer layers is a strong alkali condition of about pH = 11.0. Under a strong acid or alkali condition, the substrate and the like may possibly damaged. For example, as a substrate of a photoelectric conversion device, the use of an anodized substrate of an Al base with an $Al_2O_3$ anodized film formed on a surface of the base material is proposed as described, for example, in Japanese Unexamined Patent Publication No. 2000-349320. Since such substrate has low acid and alkali resistance, it is preferable that the buffer layer is formed under a moderate pH condition of a pH value of about 3.0 to about 8.0.

The present invention has been developed in view of the circumstances described above, and it is an object of the present invention to provide a technology for forming a metal oxide film covering an underlayer without any cracks. It is a further object of the present invention to provide a technology for forming a metal oxide film covering an underlayer without any cracks under a moderate pH condition of a pH value of about 3.0 to about 8.0.

## SUMMARY OF THE INVENTION

A layered film manufacturing method of the present invention is a method, including:

a process (A) for forming a particle layer of a plurality of one or more types of particles consisting mainly of a metal oxide and/or a metal hydroxide; and
a process (B) for forming, using a reaction solution which includes one or more types of metal ions, a metal oxide layer consisting mainly of an oxide of the one or more types of metal ions on the particle layer so as to cover the particle layer without any cracks by a liquid phase method under a pH condition in which at least a portion of the plurality of particles remains without being dissolved by the reaction solution,
whereby a layered film having a layered structure of the particle layer and the metal oxide layer is manufactured.

The term "consisting mainly of XXX", "major component", or "YYY-based" as used herein means that the XXX, major component, or YYY is a component accounting for 20 mass% or more unless otherwise specifically indicated.
According to the layered film manufacturing method of the present invention, a metal oxide layer covering an underlayer without any cracks may be formed. According to the layered film manufacturing method of the present invention, a metal oxide film having less surface unevenness than the nanowire film described in Non-patent Document 3 and covering an underlayer without any cracks may be formed. In the layered film manufacturing method of the present invention, a metal oxide film covering an underlayer without any cracks may be formed under a moderate pH condition of about pH 3.0 to 8.0 by appropriately selecting the reaction solution.

## BRIEF DESCRIPTION OF THE DRAWINGS

Figure 1 is a schematic cross-sectional view of a photoelectric conversion device according to an embodiment of the present invention.
Figure 2 illustrates schematic cross-sectional views of anodized substrates.
Figure 3 is a perspective view of an anodized substrate, illustrating a manufacturing method thereof.
Figure 4A is a TEM photograph of ZnO particles in dispersion solution A.
Figure 4B is a TEM photograph of ZnO particles in dispersion solution B.
Figure 4C is a TEM photograph of Mg doped ZnO particles in dispersion solution C.
Figure 5 shows SEM photographs of Example 1.
Figure 6 shows SEM photographs of Example 2.
Figure 7 shows SEM photographs of Example 4.
Figure 8 shows SEM photographs of Example 5.
Figure 9 shows SEM photographs of Example 6.
Figure 10 shows SEM photographs of Comparative Example 1.
Figure 11 shows SEM photographs of Comparative Example 2.
Figure 12 shows SEM photographs of Comparative Example 3.
Figure 13 shows SEM photographs of Comparative Example 4.
Figure 14 shows SEM photographs of Comparative Example 5.
Figure 15 shows SEM photographs of Comparative Example 6.
Figure 16A is a graph illustrating the relationship between wavelength and diffuse reflection factor.
Figure 16B is a graph illustrating the relationship between photon energy and $(LnT)^2$.
Figure 16C illustrates measurement results of bandgap values.

## DESCRIPTION OF THE PREFERRED EMBODIMENTS

Hereinafter, the present invention will be described in detail.

[Layered Film Manufacturing Method]

A layered film manufacturing method of the present invention includes a process (A) for forming a particle layer of a plurality of one or more types of particles consisting mainly of a metal oxide and/or a metal hydroxide, and a process (B) for forming, using a reaction solution which includes one or more types of metal ions, a metal oxide layer consisting mainly of an oxide of the one or more types of metal ions on the particle layer so as to cover the particle layer without any cracks by a liquid phase method under a pH condition in which at least a portion of the plurality of particles remains without being dissolved by the reaction solution, whereby a layered film having a layered structure of the particle layer and the metal oxide layer is manufactured.

An attempt to cause a crystal growth of a metal oxide layer directly on an underlayer may sometimes result in that a large crystal is deposited instead of a film due to unsuccessful control of the crystal growth (Comparative Examples 1 and 2 under [Examples] to be described later).

In the layered film manufacturing method of the present invention, a particle layer consisting mainly of a metal oxide and/or a metal hydroxide is formed prior to forming a metal oxide layer by a liquid phase method. In the present invention, the crystal growth of a metal oxide layer can be successfully controlled by such a particle layer and a metal oxide layer covering an underlayer without any cracks may be formed. The reason is not exactly clear, but it can be thought that the particle layer functions as a core, serving as the starting point of crystal growth or a catalyst for crystal growth. Although not exactly clear, the particle layer can be thought also to have a function to encourage spontaneous core generation in the reaction solution and the like.

In the present invention, the particle layer is a nonmetal and, therefore, a layered film of semiconductor films may be formed. The layered film of the present invention can be used as a constituent film of a photoelectric conversion device. The layered film of the present invention can be used as at least one of a buffer layer, a window layer, and a light transparent conductive layer (transparent electrode).

<Process (A)>

Preferably, the process (A) is performed by a method that applies a dispersion solution which includes a plurality of particles (particle dispersion solution) or a CBD (chemical bath deposition) method to deposit a plurality of particles.

There is not any specific restriction on the solvent of the particle dispersion solution, and water, various types of alcohols, methoxypropyl acetate, toluene, and the like may be used. Preferably, the solvent is selected in view of the affinity for the surface of a substrate. If there is not any specific restriction, water is preferable since it causes less environmental burden. There is not any specific restriction on the particle concentration (solid content concentration) in the particle dispersion solution and is preferable to be 1 to 50 mass%. There is not any specific restriction on the application method of the particle dispersion solution, and a dipping method in which the substrate is dipped in the particle dispersion solution, a spray coating method, a dip coating method, a spin coating method, and the like may be used. For examples of preparation and application methods of particle dispersion solutions, refer to Examples 1 to 6 to be described later. After applying the particle dispersion solution on the substrate, a particle layer may be formed through a process of removing the solvent.

A particle layer may also be formed by directly applying on a substrate a plurality of dry particles obtained by heating a particle dispersion solution.

The "CBD method" is a method that uses, as the reaction solution, a metal ion solution having such a concentration and a pH value as to fall in an oversaturated state by the equilibrium represented by a general formula, $[M(L)_i]^{m+} \Leftrightarrow M^{n+} + iL$ (where: M is a metal element; L is a ligand; and m, n, and i represent positive numbers), and deposits a crystal slowly on a substrate under a stable environment by forming a complex of metal ion M. As for the method of depositing a plurality of particles on a substrate by the CBD method, the method described, for example, in G. Hodes, "Semiconductor and ceramic nanoparticle films deposited by chemical bath deposition", Physical Chemistry Chemical Physics, Vol. 9, pp. 2181-2196, 2007 may be cited.

There is not any specific restriction on a major component of the particle layer as long as it is one or more types of metal oxides and/or a metal hydroxide. The major component of the particle layer may include ZnO, MgO, $Al_2O_3$, $In_2O_3$, $SiO_2$, $SnO_2$, $TiO_2$, barium titanate, $SrTiO_3$, PZT (lead zirconate tantanate), YBCO ($YBaCu_3O_{7-x}$), YSZ (yttrium-stabilized zirconia), YAG ($Y_3Al_5O_{12}$ or $3Y_2O_3 \cdot 5Al_2O_3$, or a composite oxide of these or an oxide such as a solid solution (e.g., ITO ($In_2O_3/SnO_2$, $Zn_{1-x}Mg_xO$, and the like), and a hydroxide containing a metal identical of these oxides.

Preferably, the major component of the particle layer for use in the application of a photoelectric conversion device or the like is a semiconductor, and one or more types of zinc compounds, such as ZnO, $Zn(OH)_2$, and the like, or $SnO_2$ is preferable, among of which ZnO is particularly preferable.

There is not any specific restriction on the shape of a plurality of particles forming the particle layer. In the process (A), a particle layer which includes particles having, for example, at least one of a rod-like shape, a plate-like shape, and a spherical shape may be formed. A plurality of particles forming the particle layer may be synthesized or may obtain from the market. In [Examples] which will be described later, synthetic examples and commercial products of ZnO particles having a rod-like shape and a spherical shape are used. A method of synthesizing ZnO particles having a plate-like shape is described, for example, in L.P. Bauermann, "Heterogeneous Nucleation of ZnO Using Gelatin as the Organic Matrix", Chemistry of Materials, Vol. 18, No. 8, pp. 2016-2020, 2006.

Preferably, variations in the shape and size of a plurality of particles forming the particle layer are small since crystal growth progresses uniformly over the entire substrate in the latter process (B). There is not any specific restriction on the density of a plurality of particles applied on the substrate. If the density of a plurality of particles applied on a substrate is too small, the particles may not fully function as the core of crystal growth and/or catalyst. Therefore, a higher density is more preferable for a plurality of particles applied on the substrate. As shown in Examples 1 to 6, to be described later, it is preferable that a plurality of particles is applied so as to cover the entire substrate.

There is not any specific restriction on the thickness of the particle layer, which is preferable to be 2 nm to 1 μm because it allows successful control of crystal growth of a metal oxide layer. Preferably, the in-plane variation in the thickness of the particle layer is small since the reaction progresses uniformly over the entire substrate.

There is not any specific restriction on the average particle diameter of the plurality of particles forming the particle layer and may be a size that does not exceed the entire thickness of the layered film determined according to the application. Preferably, the average particle diameter of the plurality of particles forming the particle layer is as small as possible within a range that allows the particles to fully function as the core of crystal growth and/or catalyst. Preferably, the particle layer is formed of the plurality of particles having an average particle diameter of 2 to 50 nm (if the particles have a non-spherical shape, the average particle diameter refers to an average sphere-equivalent diameter) in the process (A) because it allows successful control of crystal growth in the latter process (B). More preferably, the average particle diameter of the plurality of particles is 2 to 10 nm.

As used herein, "average particle diameter" refers to an average particle diameter obtained from a TEM image. More specifically, the average particle diameter is obtained by observing sufficiently dispersed particles with a transmission electron microscope (TEM), measuring each particle using image analysis grain size distribution measuring software "Mac-View" of Mountech Co., Ltd for imaged particle image file information, and calculating 50 particles selected randomly.

There is not any specific restriction on the average crystallite diameter of the plurality of particles forming the particle layer. Preferably, a particle layer with an average crystallite diameter of 2 to 50 nm is formed in the process (A). Where each particle is formed of a monocrystalline body, the crystallite diameter is equal to the average particle diameter of the particles, and if each particle is formed of a polycrystalline body, the crystallite diameter is smaller than the average particle diameter of the particles.

As used herein, "crystallite diameter" refers to a crystallite diameter obtained by performing an XRD analysis to obtain the full-width at half maximum of the diffraction peak and based on the Scherrer's equation represented by Formula (a) below. In Formula (a), D is crystallite diameter, K is form factor, λ is wavelength of X-ray, β is full-with at half maximum corrected in equipment dependent diffraction peak broadening, and θ is diffraction angle. The crystallite diameter is obtained with K = 0.9. The correction of diffraction angle is implemented based on Warren equation represented by Formula (b) below. In Formula (b), B is full-width at half maximum of diffraction peak in a sample and b is full-width at half maximum of diffraction peak of a standard sample having a sufficiently large crystallite diameter without lattice distortion. As for the standard sample, a Si monocrystalline body is used.

$$D = K\lambda/\beta\cos\theta \text{ --------------- (a)}$$

$$\beta = (B^2 - b^2)^{1/2} \text{ ------------- (b)}$$

In the application of a constituent film of a photoelectric conversion device or the like, there is not any specific restriction on the relationship in crystallite diameter between the photoelectric conversion layer and particle layer. There may be a case in which the crystallite diameter of the particle layer is greater than, smaller than, or equal to that of the photoelectric conversion layer.

Examples of crystallite diameters of CIGS photoelectric conversion layers actually measured by the present inventor were, for example, 25 to 30 nm, and examples of crystallite diameters of ZnO particle layers actually measured by the present inventor were, for example, 2 to 25 nm. Although it is not exactly clear, the present inventor believes that it is preferable that the crystallite diameter of the ZnO particle layer is smaller than that of the photoelectric conversion layer.

<Process (B)>

In the process (B), it is preferable that a metal oxide layer is formed by a CBD method. Preferably, the reaction solution used in the process (B) includes one or more types of metal ions, a nitrate ion, and a reducing agent that reduces an $NO_3^-$ ion to an $NO_2^-$ ion. Preferably, the process (B) includes a reaction process in which the metal ions and a complex formed by the reducing agent coexist. Preferably, the reaction solution used in the process (B) includes one or more types of amine borane compounds as the reducing agent. The amine borane compound may include dimethylamine borane, trimethylamine borane, and the like. Preferably, the reaction solution used in the process (B) includes dimethylamine borane as the reducing agent.

There is not any specific restriction on the major component of the metal oxide layer as long as it is one or more types of metal oxides and may include ZnO, MgO, $Al_2O_3$, $In_2O_3$, $SiO_2$, $SnO_2$, $TiO_2$ $BaTiO_3$, $SrTiO_3$, PZT (lead zirconate tantanate), YBCO ($YBaCu_3O_{7-x}$), YSZ (yttrium-stabilized zirconia), YAG ($Y_3Al_5O_{12}$ or $3Y_2O_3{\cdot}5Al_2O_3$, or a composite oxide of these or an oxide such as a solid solution (e.g., ITO ($In_2O_3/SnO_2$, $Zn_{1-x}Mg_xO$, and the like).

Preferably, the major component of the particle layer for use in the application of a constituent film of a photoelectric conversion device or the like is a semiconductor and ZnO, $SnO_2$, or the like is preferable, in which ZnO or the like is particularly preferable.

Preferably, when forming a ZnO layer, the reaction solution includes, for example, zinc nitrate and dimethylamine borane. The present inventor has succeeded in forming a ZnO layer covering an underlayer without any cracks by first forming a ZnO particle layer and then forming the ZnO layer by a CBD method using such a reaction solution (Examples 1 to 6 to be described later).

There is not any specific restriction on the reaction condition when a reaction solution which includes a metal ion, a nitrate ion, and an amine borane compound, such as dimethylamine borane. Preferably, the reaction temperature is 40 to 95°C, and more preferably 50 to 85°C. Although depending on the reaction temperature, the reaction time is preferable to be 5 minutes to 72 hours, and more preferable to be 15 minutes to 24 hours. The pH condition may be any condition as long as it causes at least a portion of the particle layer to remain without being dissolved by the reaction solution. When a metal ion, a nitrate ion, and an amine borane compound, such as dimethylamine borane are used, a metal oxide film may be formed by keeping the pH value of 3.0 to 8.0 from the start to the end of the reaction.

The reaction path in a reaction solution that uses zinc nitrate and dimethylamine borane is believed to be as follows (Non-patent Document 1 and the like cited under "Description of the RelatedArt") .

$$Zn(NO_3)_2 \rightarrow Zn^{2+} + 2NO_3^- \qquad (1)$$

$$(CH_3)_2NHBH_3 + H_2O \rightarrow BO_2^- + (CH_3)_2NH + 7H^+ + 6e^- \qquad (2)$$

$$NO_3^- + H_2O + 2e^- \rightarrow NO_2^- + 2OH^- \qquad (3)$$

$$Zn^{2+} + 2OH^- \rightarrow Zn(OH)_2 \qquad (4)$$

$$Zn(OH)_2 \rightarrow ZnO + H_2O \qquad (5)$$

In the reaction above, $BO_2^-$ in Formula 2 forms an amine compound, and the reaction includes a reaction process in which $Zn^{2+}$ and the amine compound coexist. Preferably, in the reaction above, the reaction takes place under a pH condition of a low solubility of ZnO. The relationship between pH and solubility of various types of Zn containing ions in a reaction solution is described, for example, in Figure 7 of S. Yamabi and H. Imai, "Growth conditions for wurtzite zinc oxide films in aqueous solutions", Journal of Materials Chemistry, Vol. 12, pp. 3773-3778, 2002. In the reaction described above, the solubility of ZnO is small in the pH range from 3.0 to 8.0, and the reaction proceeds favorably. That is, the reaction proceeds favorably under a moderate pH condition, not under a strong acid or alkali condition, which has less impact on the substrate or the like and, therefore, preferable.

The reaction solution which includes a metal ion, a nitrate ion, and an amine borane compound, such as dimethylamine borane, may include any component other than the essential components. Such a type of reaction solution can be an aqueous solution, does not require a high reaction temperature, and reaction takes place under a moderate pH condition, that is, environmentally friendly and, therefore, preferable.••

In the application of a constituent film of a photoelectric conversion device or the like, there is not any specific restriction on the relationship in bandgap value between the particle layer and metal oxide layer. Preferably, the particle layer and metal oxide layer are formed with a composition that causes the difference between the bandgap values of the metal oxide layer and particle layer to be 0 to 0.15 eV. For example, if the particle layer and metal oxide layer are formed with the same composition, the difference between bandgap values of the metal oxide layer and particle layer may fall within the range described above. A method of measuring the "bandgap value" will be described in the section under "Examples".

In the application of a constituent film of a photoelectric conversion device or the like, the following should be satisfied: bandgap value of particle layer > bandgap value of photoelectric conversion layer, and bandgap value of metal oxide layer > bandgap value of photoelectric conversion layer.

There is not any specific restriction on the differences between the bandgap values of the particle layer and photoelectric conversion layer, and between the bandgap values of the metal oxide layer and photoelectric conversion layer. When each of particle layer and metal oxide layer is formed mainly of ZnO, the bandgap values of these layers are about 3.2 to 3.4 eV. Examples of bandgap values of photoelectric conversion layers are about 1.05 to about 1.70 eV for a CIGS layer (in CIGS, the bandgap value can be changed by changing Ga concentration) and about 1.5 eV for a CIS layer. The difference between the bandgap value of a ZnO particle layer or a ZnO layer and the bandgap value of a CIGS is, for example, about 1.6 to about 2.25 eV, and the difference between the bandgap value of a ZnO particle layer or a ZnO layer and the bandgap value of a CIS is, for example, about 1.8 eV.

In the layered film manufacturing method of the present invention, a particle layer consisting mainly of a metal oxide or a metal hydroxide is formed prior to forming a metal oxide layer by a liquid phase method, and crystal growth of the metal oxide layer is controlled favorably by the particle layer, whereby the metal oxide layer covering an underlayer without any cracks can be formed. According to the layered film manufacturing method of the present invention, a metal oxide film having less surface unevenness than the nanowire film described in Non-patent Document 3 and covering an underlayer without any cracks may be formed. In the layered film manufacturing method of the present invention, a metal oxide film covering an underlayer without any cracks may be formed under a moderate pH condition of about pH 3.0 to 8.0 by appropriately selecting the reaction solution.

In the present invention, the reaction can take place under a moderate pH condition, which secures the substrate or the like from being damaged. For example, as a substrate for a photoelectric conversion device, the use of an anodized substrate, in which an $Al_2O_3$ anodized film is formed on an Al base, is proposed. Such a substrate does not have high acid and alkali resistance. In the present invention, however, the reaction takes place under a moderate pH condition, so that even when such a substrate is used, the substrate is secured from being damaged and a high quality photoelectric conversion device may be provided.

[Layered Film]

Layered films of the present invention, which will be described below, may be provided by the layered film manufacturing method of the present invention described above. A first layered film of the present invention is a layered film formed by the layered film manufacturing method described above. A second layered film of the present invention is a layered film having a layered structure of a particle layer formed of a plurality of one or more types of particles consisting mainly of a metal oxide and/or a metal hydroxide, and a metal oxide layer consisting mainly of one or more types of metal oxides and covering the particle layer without any cracks.

For specific cross-sectional structures of the layered films of the present invention, refer to SEM photographs of "Examples" to be described later. In the drawings, the NP layer represents the particle layer.

In the layered films of the present invention, there is not any specific restriction on the average particle diameter of a plurality of particles forming the particle layer (if the particles have a non-spherical shape, it refers to an average sphere-equivalent diameter) and is preferable to be 2 to 50 nm, and particularly preferable to be 2 to 10 nm. In the layered films of the present invention, there is not any specific restriction on the average crystallite diameter of a plurality of particles forming the particle layer and is preferable to be 2 to 50 nm. In the layered films of the present invention, there is not any specific restriction on the average crystallite diameter of the metal oxide layer and is preferable to be not less than 100 nm.

In the application of a constituent film of a photoelectric conversion device or the like, the layered films of the present invention are preferable to be semiconductor films. In such a configuration, there is not any specific restriction on the difference between the bandgap values of the metal oxide layer and particle layer and is preferable to be 0 to 0.15 eV.

In the application of a constituent film of a photoelectric conversion device or the like, there is not any specific restriction on the major component of the metal oxide layer and is preferable to be ZnO or the like. In the application of a constituent film of a photoelectric conversion device or the like, there is not any specific restriction on the major component of the particle layer and is preferable to be ZnO or the like.

There is not any specific restriction on the shape of particles forming the particle layer. As for the particle layer, a particle layer which includes at least one type of rod-like particles, plate-like particles, and spherical particles may be formed.

In the layered films of the present invention, there is not any specific restriction on the film thickness of each layer. Preferably, the thickness of the particle layer is 2 nm to 1 μm because it allows successful control of crystal growth of the metal oxide layer. In the application of a constituent film of a photoelectric conversion device or the like, the film thickness of the metal oxide layer is preferable to be 3 nm to 10 μm, and particularly preferable to be 50 nm to 200 nm.

[Photoelectric Conversion Device Manufacturing Method]

A first photoelectric conversion device manufacturing method of the present invention is a method of manufacturing a photoelectric conversion device having a layered structure of a lower electrode (back contact electrode), a photoelectric conversion semiconductor layer that generates a current by absorbing light, a buffer layer, a light transparent conductive layer (transparent electrode), and an upper electrode (grid electrode) on a substrate, in which the buffer layer and/or the light transparent conductive layer is manufactured by the layered film manufacturing method of the present invention described above.

A second photoelectric conversion device manufacturing method of the present invention is a method of manufacturing a photoelectric conversion device having a layered structure of a lower electrode (back contact electrode), a photoelectric conversion semiconductor layer that generates a current by absorbing light, a buffer layer, a window layer, a light transparent conductive layer (transparent electrode), and an upper electrode (grid electrode) on a substrate, in which at least one of the buffer layer, window layer, and light transparent conductive layer is manufactured by the layered film manufacturing method of the present invention described above.

According to the present invention, a photoelectric conversion device may be formed with reduced environmental burden and without damaging the substrate or the like.

[Photoelectric Conversion Device]

A first photoelectric conversion device of the present invention is a device having a layered structure of a lower electrode (back contact electrode), a photoelectric conversion semiconductor layer that generates a current by absorbing light, a buffer layer, a light transparent conductive layer (transparent electrode), and an upper electrode (grid electrode) on a substrate, in which the buffer layer and/or the light transparent conductive layer is formed of the layered film of the present invention described above.

A first photoelectric conversion device of the present invention is a device having a layered structure of a lower electrode (back contact electrode), a photoelectric conversion semiconductor layer that generates a current by absorbing light, a buffer layer, a window layer, a light transparent conductive layer (transparent electrode), and an upper electrode (grid electrode) on a substrate, in which at least one of the buffer layer, window layer, and light transparent conductive layer is the layered film of the present invention described above.

There is not any specific restriction on the substrate, and a glass substrate, a metal substrate, such as a stainless steel substrate, on which an insulating film is formed, an anodized substrate which includes an Al base consisting mainly of Al and has an $Al_2O_3$-based anodized film formed on at least one surface side of the Al base, an anodized substrate which includes a composite base formed of an Fe material consisting mainly of Fe with an Al material consisting mainly of Al combined to at least one surface side of the Fe material and has an $Al_2O_3$-based anodized film formed on at least one surface side of the composite base, an anodized substrate which includes a base formed of an Fe material consisting mainly of Fe with an Al film consisting mainly of Al formed on at least one surface side of the Fe material and has an $Al_2O_3$-based anodized film formed on at least one surface side of the base, a resin substrate, such as a polyimide substrate, or the like may be used.

A flexible substrate, such as a metal substrate with an insulating film formed on a surface of the substrate, an anodized film, or a resin substrate, is preferable because it allows production through a continuous process.

In view of the thermal expansion coefficient, heat resistance, and electrical insulation, one of the following is particularly preferable: an anodized substrate which includes an Al base consisting mainly of Al and has an $Al_2O_3$-based anodized film formed on at least one surface side of the Al base, an anodized substrate which includes a composite base formed of an Fe material consisting mainly of Fe with an Al material consisting mainly of Al combined to at least one surface side of the Fe material and has an $Al_2O_3$-based anodized film formed on at least one surface side of the composite base, and an anodized substrate which includes a base formed of an Fe material consisting mainly of Fe with an Al film consisting mainly of Al formed on at least one surface side of the Fe material and has an $Al_2O_3$-based anodized film formed on at least one surface side of the base.

[Photoelectric Conversion Device]

A structure of a photoelectric conversion device according to an embodiment of the present invention will be described with reference to the accompanying drawings. Figure 1 is a schematic cross-sectional view of the photoelectric conversion device. Figure 2 illustrates schematic cross-sectional views of substrates. Figure 3 is a perspective view of a substrate, illustrating a manufacturing method thereof. In the drawings, each component is not drawn to scale in order to facilitate visual recognition.

Photoelectric conversion device 1 is a device having substrate 10 on which lower electrode (back contact electrode) 20, photoelectric conversion layer 30, buffer layer 40, window layer 50, light transparent conductive layer (transparent electrode) 60, and upper electrode (grid electrode) 70 are layered in this order.

(Substrate)

Substrate 10 is a substrate obtained by anodizing at least one surface side of Al base 11 consisting mainly of Al. Substrate 10 may be a substrate of Al base 11 having anodized film 12 on each side as illustrated on the left of Figure 2 or a substrate of Al base 11 having anodized film 12 on either one of the sides as illustrated on the right of Figure 2. Here, anodized film 12 is an $Al_2O_3$-based film.

Preferably, substrate 10 is a substrate of Al base 11 having anodized film 12 on each side as illustrated on the left of Figure 2 in order to prevent warpage of the substrate due to the difference in thermal expansion coefficient between Al and $Al_2O_3$, and detachment of the film due to the warpage during the device manufacturing process.

Anodization may be performed by immersing Al base 11, which is cleaned, smoothed by polishing, and the like as required, as an anode with a cathode in an electrolyte, and applying a voltage between the anode and cathode. As for the cathode, carbon, aluminum, or the like is used. There is not any specific restriction on the electrolyte, and an acid electrolyte solution which includes one or more types of acids, such as sulfuric acid, phosphoric acid, chromic acid, oxalic acid, sulfamic acid, benzenesulfonic acid, amido-sulfonic acid, and the like, is preferably used.

There is not any specific restriction on the anodizing conditions and dependent on the electrolyte used. As for the anodizing conditions, for example, the following are appropriate: electrolyte concentration of 1 to 80 mass%, solution temperature of 5 to 70°C, current density of 0. 005 to 0. 60 A/cm$^2$, electric voltage of 1 to 200 V, and electrolyzing time of 3 to 500 minutes.

As for the electrolyte, a sulfuric acid, a phosphoric acid, an oxalic acid, or a mixture thereof may preferably be used. When such an electrolyte is used, the following conditions are preferable: electrolyte concentration of 4 to 30 mass%, solution temperature of 10 to 30°C, current density of 0.05 to 0.30 A/cm$^2$, and electric voltage of 30 to 150 V.

As shown in Figure 3, when Al base 11, consisting mainly of Al, is anodized, an oxidization reaction proceeds from surface 11s in a direction substantially perpendicular to surface 11s, and $Al_2O_3$-based anodized film 12 is formed. Anodized film 12 generated by the anodization has a structure in which multiple fine columnar bodies, each having a substantially regular hexagonal shape in plan view, are tightly arranged. Each fine columnar body 12a has a fine pore 12b, in substantially the center, extending substantially linearly in a depth direction from surface 11s, and the bottom surface of each fine columnar body 12a has a rounded shape. Normally, a barrier layer without any fine pore 12b is formed at a bottom area of fine columnar bodies 12a. Anodized film 12 without any fine pore 12b may also be formed by appropriately arranging the anodizing conditions.

There is not any specific restriction on the thicknesses of Al base 11 and anodized film 12. Preferably, the thickness of Al base 11 prior to anodization is, for example, 0.05 to 0.6mm, and more preferably 0.1 to 0.3mm in view of the mechanical strength of substrate 10, and reduction in the thickness and weight. When the electrical insulation, mechanical strength, and reduction in the thickness and weight are taken into account, a preferable range of the thickness of anodized film 12 is 0.1 to 100$\mu$m.

(Lower Electrode)

There is not any specific restriction on the major component of lower electrode (back contact electrode) 20, and Mo, Cr, W, or a combination thereof is preferably used, in which Mo is particularly preferable. There is not any specific restriction on the film thickness of lower electrode (back contact electrode) 20 and about 200 to 1000 nm is preferable.

(Photoelectric Conversion Layer)

There is not any specific restriction on the major component of photoelectric conversion layer 30, and is preferable to be at least one type of chalcopyrite compound semiconductor, and more preferable to be at least one type of compound semiconductor formed of group Ib element, group IIIb element, and group VIb element, in view of high photoelectric conversion efficiency.

Preferably, the major component of photoelectric conversion layer 30 is at least one type of compound semiconductor formed of at least one type of group Ib element selected from the group consisting of Cu and Ag, at least one type of group IIIb element selected from the group consisting of Al, Ga, and In, and at least one type of group VIb element selected from the group consisting of S, Se, and Te.

As for the compound semiconductors described above, the following may be cited as examples: $CuAlS_2$, $CuGaS_2$, $CuInS_2$, $CuAlSe_2$, $CuGaSe_2$, $AgAlS_2$, $AgGaS_2$, $AgInS_2$, $AgAlSe_2$, $AgGaSe_2$, $AgInSe_2$, $AgAlTe_2$, $AgGaTe_2$, $AgInTe_2$, $Cu(In, Al)Se_2$, $Cu(In, Ga) (S, Se)_2$, $Cu_{1-z}In_{1-x}Ga_xSe_{2-y}S_y$ (in the formula, $0 \leq x \leq 1$, $0 \leq y \leq 2$, $0 \leq z \leq 1$) (CI(G)S), $Ag (In, Ga)Se_2$, $Ag (In, Ga) (S, Se)_2$, and the like.

There is not any specific restriction on the film thickness of photoelectric conversion layer 30, which is preferable to be 1.0 to 3.0 $\mu$m and more preferable to be 1.5 to 2.0 $\mu$m.

(Buffer Layer, Window Layer, and Light Transparent Conductive Layer)

Buffer layer 40 is a layer provided for (1) prevention of photogenerated carrier recombination (2) band discontinuity alignment (3) lattice matching and (4) compensation for surface unevenness of photoelectric conversion layer. Window layer 50 is an intermediate layer for capturing light. Light transparent conductive layer (transparent electrode) 60 is a layer that captures light and functions as an electrode, in cooperation with lower electrode 20 as a pair, for flowing an electric current generated in photoelectric conversion layer 30.

In the present embodiment, at least one of buffer layer 40, window layer 50, and light transparent conductive layer 60 is a layered film manufactured by the layered film manufacturing method of the present invention described above. Conventionally, the window layer and light transparent conductive layer are formed by a gas phase method. But these layers may also be formed by a liquid phase method at a low cost by applying the method of the present invention.

When buffer layer 40 is formed by the layered film manufacturing method of the present invention, a preferable composition is n-ZnO or the like. There is not any specific restriction on the film thickness of buffer layer 40, which is preferable to be 10 nm to 2 μm and more preferable to be 15 to 200 nm. When window layer 50 is formed by the layered film manufacturing method of the present invention, a preferable composition is i-ZnO or the like. There is not any specific restriction on the film thickness of window layer 50, which is preferable to be 10 nm to 2 μm and more preferable to be 15 to 200 nm. When light transparent conductive layer 60 is formed by the layered film manufacturing method of the present invention, a preferable composition is n-ZnO, such as ZnO:Al or the like. There is not any specific restriction on the film thickness of light transparent conductive layer 60 and is preferable to be 50 nm to 2 μm.

Window layer 50 is not essential, and photoelectric conversion devices without window layer 50 are also found. For a photoelectric conversion device without window layer 50, at least one of buffer layer 40 and light transparent conductive layer 60 is a layered film formed by the layered film manufacturing method of the present invention.

(Upper Electrode)

There is not any specific restriction on the major component of upper electrode (grid electrode) 70, and Al and the like may be used. There is not any specific restriction on the film thickness of upper electrode 70 and is preferable to be 0.1 to 3 μm.

Photoelectric conversion device 1 of the present embodiment is structured in the manner as described above. Photoelectric conversion device 1 may be preferably used in a solar cell apparatus. Photoelectric conversion device 1 may be turned into a solar cell apparatus by attaching, as required, a cover glass, a protection film, and the like. The present invention is not limited to the embodiments described above, and design changes may be made as appropriate without departing from the sprit of the present invention.

[Examples]

Examples of the present invention and Comparative Examples will be described.

<Substrates>

The following six substrates were provided:

Substrate 1: a glass substrate (Matsunami Glass Ind. Ltd, large slide glass, white edge-polished No2, S9112);
Substrate 2: an anodized aluminum substrate with Mo on which a CIGS layer is formed;
The manufacturing process of Substrate 2 was as follows. A Mo lower electrode layer was formed on an anodized aluminum substrate, obtained by anodizing both sides of an Al base, by sputtering with a thickness of 0.8 μm. Then a $Cu(In_{0.7}Ga_{0.3})Se_2$ layer was formed on the substrate using a three-stage process, known as one of the methods of forming CIGS layers, with a film thickness of 1.8 μm.
Substrate 3: a substrate of Si wafer with a thermally-oxidized film (100 μm thick $SiO_2$ layer) formed thereon on which a ZnO layer (continuous film, 100 nm thick) is formed by sputtering;
Substrate 4: a substrate of Si wafer on which a thermally-oxidized film (100 μm thick $SiO_2$ layer) is formed;
Substrate 5: a glass substrate on which a zinc acetate dihydrate layer is formed (The following two literatures propose to grow a ZnO layer after providing a zinc acetate dehydrate layer. Substrate 5 was prepared in accordance with the methods described in the literatures. X. Hu et al., "In situ forced hydrolysis-assisted fabrication and photo-induced electrical property in sensor of ZnO nanoarrays", Journal of Colloid and Interface Science, Vol. 325, pp. 459-463, 2008, and X. Hu et al., "Micropatterning of ZnO Nanoarrays by Forced Hydrolysis of Anhydrous Zinc Acetate", Langmuir, Vol. 24, pp. 7614-7617, 2008); and
Substrate 6: a soda lime glass substrate (SLG) with Mo on which a CIGS layer is formed. The Mo layer and CIGS layer were formed in a manner identical to that of Substrate 2.

<ZnO Particle Dispersion Solution A>

5.85 g of zinc acetate anhydride was added to a three neck glass flask containing 300 ml of methanol and agitated sufficiently. While maintaining the agitation, 1.8 ml of pure water was added and heated to 60°C. Separately, 3.48 g of KOH was completely dissolved in 150 ml of methanol, which was then added to the three neck glass flask. The flask was maintained at 60°C for two hours and the temperature was increased to 90°C to concentrate the solution until the total amount is reduced to 75 ml and further the solution was maintained at 60°C for five hours. In this way, multiple ZnO-based particles were generated in a reaction solution. The particles obtained were sufficiently cleaned by methanol washing, ethanol washing, and pure water washing. The particles obtained were dispersed in water and a ZnO particle dispersion aqueous solution A was obtained. The solid content was 6 mass%.

Figure 4A shows a TEM photograph of the synthesized ZnO particles. The particles obtained were rod-like particles and had an average sphere-equivalent diameter of 20 nm. The particles obtained were confirmed to have a wurtzite type crystal structure by XRD analysis.

<ZnO Particle Dispersion Solution B>

As the ZnO particle dispersion solution B, a zinc oxide dispersion solution (trade name "NANOBYK-3840", solvent: water) available from BYK was prepared. Figure 4B shows a TEM photograph of the ZnO particles in the dispersion solution B. The properties of the dispersion solution used were as follows: rod-like particles; average sphere-equivalent diameter of 39 nm; and solid content of 44 mass%.

<ZnO Particle Dispersion Solution C>

As the ZnO particle dispersion solution C, an Mg doped ZnO particle dispersion solution was prepared. 5.85 g of zinc acetate anhydride (31.8 mmol) was added to a three neck glass flask containing 300 ml of methanol and agitated sufficiently. While maintaining the agitation, 1.36 g of magnesium acetate tetrahydrate (31.8/5 mmol) and 1.34 ml of pure water were added and heated to 60°C. Separately, 3.48 g of KOH was completely dissolved in 150 ml of methanol, which was then added to the three neck glass flask. The flask was maintained at 60°C for two hours and the temperature was increased to 90°C to concentrate the solution until the total amount is reduced to 75 ml and further the solution was maintained at 60°C for four hours. In this way, multiple Mg doped ZnO-based particles were generated in a reaction solution. The particles obtained were sufficiently cleaned by methanol washing, ethanol washing, and pure water washing. The particles obtained were dispersed in water and a ZnO particle dispersion aqueous solution C was obtained. The solid content was 6 mass%.

ICP-AES analysis results showed that the composition of the synthesized Mg doped ZnO particles was $ZnO_{0.81}Mg_{0.19}O$. According to a known literature, the solid solubility limit of Mg in ZnO is 0.15 mol%. In view of this, in the prepared particles, it can be thought that, for example, a portion of Mg is adsorbed on the surfaces of the particles without solidifying with ZnO.

Figure 4C shows a TEM photograph of the synthesized Mg doped ZnO particles. The particles obtained were spherical particles with an average particle diameter of 12 nm. The particles obtained were confirmed to have a wurtzite type crystal structure by XRD analysis.

<ZnO Particle Dispersion Solution D>

As the ZnO particle dispersion solution D, a zinc oxide dispersion solution (trade name "NANOBYK-3841", solvent: methoxypropyl acetate) available from BYK was prepared. The dispersion solution D includes particles identical to those of dispersion solution B but differs in solvent.

<Reaction Solution X (Zinc Nitrate-Dimethylamine Borane (DMAB))>

The reaction solution X was prepared by mixing an aqueous solution of 0.20M of $Zn(NO_3)_2$ and 0.1M of DMAB aqueous solution in the same volume and agitating the mixture for 15 minutes or more.

<Reaction Solution Y (Zinc Sulfate-Ammonium Chloride-NaOH>

$ZnSO_4 \cdot 7H_2O$ was added to water such that $[Zn^{2+}]$ = 0.02M, and agitated for one hour to dissolve $ZnSO_4 \cdot 7H_2O$ in the water. Then, as a complexing agent, $NH_4Cl$ was added to the solution such that $[NH_4^+]/[Zn^{2+}]$ = 30, and agitated for 30 minutes, whereby a mother liquid in which $[Zn^{2+}]$ = 0.02M was obtained. Then, water and NaOH aqueous solution were added to the mother liquor such that $[Zn^{2+}]$ = 0.01M, and pH = 12.0, whereby the reaction solution Y was prepared.

(Example 1)

ZnO particle dispersion solution A was applied on substrate 1 (glass substrate) by a spin coating method (rotation speed: 1000 rpm, rotation time: 30 seconds) which was dried at room temperature to form a ZnO particle layer. Then, a ZnO layer was grown on the ZnO particle layer by a CBD method. More specifically, the substrate on which the ZnO particle layer had been formed was immersed in 50 ml of reaction solution X temperature regulated at 85°C for 24 hours and then the substrate was taken out from the solution and dried at room temperature, whereby the ZnO layer was formed. The pH values of reaction solution X before and after the reaction were 5.43 and 6.21 respectively.

In the present example, the ZnO particle layer remained even after the reaction took place in reaction solution X, whereby a layered film of the ZnO particle layer and ZnO layer could be formed. Figure 5 shows SEM photographs of the layered film (cross-sectional and perspective photographs). In the present example, a ZnO layer covering the underlayer without any cracks could be formed. After forming each layer, an XRD analysis was performed to obtain average crystallite diameters of the ZnO particle layer and ZnO layer formed by the CBD method, the results of which were 20 nm and not less than 100 nm respectively.

(Example 2)

A layered film was formed in a manner similar to that of Example 1, except that ZnO particle dispersion solution B was used instead of ZnO particle dispersion solution A. As in Example 1, the pH values of reaction solution X before and after the reaction were 5.43 and 6.21 respectively. In the present example, the ZnO particle layer remained even after the reaction took place in reaction solution X, whereby a layered film of the ZnO particle layer and ZnO layer could be formed, as in Example 1. Figure 6 shows SEM photographs of the layered film (cross-sectional and perspective photographs). In the photographs, NP layer represents the particle layer. In the present example, a ZnO layer covering the underlayer without any cracks could be formed. After forming each layer, an XRD analysis was performed to obtain average crystallite diameters of the ZnO particle layer and ZnO layer formed by the CBD method, the results of which were 39 nm and not less than 100 nm respectively.

(Example 3)

A layered film was formed in a manner similar to that of Example 2, except that substrate 2 (an anodized aluminum substrate with Mo on which a CIGS layer is formed) was used and the reaction time of reaction solution X was changed to six hours. As in Example 1, the pH values of reaction solution X before and after the reaction were 5.43 and 6.21 respectively. In the present example, the ZnO particle layer remained even after the reaction took place in reaction solution X, whereby a layered film of the ZnO particle layer and ZnO layer could be formed, as in Example 1. In the present example, a ZnO layer covering the underlayer without any cracks could be formed, as in Example 1.

(Example 4)

A layered film was formed in a manner similar to that of Example 1, except that ZnO particle dispersion solution C was used instead of ZnO particle dispersion solution A. As in Example 1, the pH values of reaction solution X before and after the reaction were 5.43 and 6.21 respectively. In the present example, the ZnO particle layer remained even after the reaction took place in reaction solution X, whereby a layered film of the ZnO particle layer and ZnO layer could be formed, as in Example 1. Figure 7 shows SEM photographs of the layered film (cross-sectional and perspective photographs). In the present example, a ZnO layer covering the underlayer without any cracks could be formed, as in Example 1. After forming each layer, an XRD analysis was performed to obtain average crystallite diameters of the ZnO particle layer and ZnO layer formed by the CBD method, the results of which were 12 nm and not less than 100 nm respectively.

(Example 5)

A layered film was formed in a manner similar to that of Example 1, except that substrate 6 (a soda lime glass substrate (SLG) with Mo on which a CIGS layer is formed) was used and ZnO particle dispersion solution D was used instead of ZnO particle dispersion solution A. The pH values of reaction solution X before and after the reaction were 5.31 and 6.11 respectively. In the present example, the ZnO particle layer remained even after the reaction took place in reaction solution X, whereby a layered film of the ZnO particle layer and ZnO layer could be formed, as in Example 1. Figure 8 shows SEM photographs of the layered film (cross-sectional and perspective photographs). In the present example, a ZnO layer covering the underlayer without any cracks could be formed, as in Example 1. After forming each layer, an XRD analysis was performed to obtain average crystallite diameters of the ZnO particle layer and ZnO layer formed by the CBD method, the results of which were 39 nm and not less than 100 nm respectively.

(Example 6)

A layered film was formed in a manner similar to that of Example 5, except that the CBD reaction time was changed to six hours. The pH values of reaction solution X before and after the reaction were 5.31 and 5.38 respectively. In the present example, the ZnO particle layer remained even after the reaction took place in reaction solution X, whereby a layered film of the ZnO particle layer and ZnO layer could be formed, as in Example 5. Figure 9 shows SEM photographs of the layered film (cross-sectional and perspective photographs). In the present example, a ZnO layer covering the underlayer without any cracks could be formed, as in Example 5. After forming each layer, an XRD analysis was performed to obtain average crystallite diameters of the ZnO particle layer and ZnO layer formed by the CBD method, the results of which were 39 nm and not less than 100 nm respectively.

(Comparative Example 1)

An attempt was made to form a ZnO layer in a manner similar to that of Example 1, except that the ZnO particle layer was not formed. The pH values of reaction solution X before and after the reaction were 5.43 and 6.23 respectively. Figure 10 shows SEM photographs of the substrate after the reaction. In the present comparative example, huge rod-like ZnO deposits were deposited and the intended ZnO layer could not be formed.

(Comparative Example 2)

An attempt was made to form a ZnO layer in a manner similar to that of Example 3, except that the ZnO particle layer was not formed. The pH values of reaction solution X before and after the reaction were 5.43 and 6.23 respectively. Figure 11 shows SEM photographs of the substrate after the reaction. In the present comparative example, huge rod-like ZnO deposits were deposited and the intended ZnO layer could not be formed.

(Comparative Example 3)

An attempt was made to form a ZnO layer in a manner similar to that of Example 2, except that, after forming a ZnO particle layer in a manner identical to that of Example 2, a reaction was performed for 24 hours using reaction solution Y instead of reaction solution X. The pH values of reaction solution Y before and after the reaction were 12.0 and 11.44 respectively. Figure 12 shows SEM photographs of the substrate after the reaction. In the present comparative example, a ZnO nanowire film in which multiple ZnO nanowires extending side by side in a direction substantially perpendicular to the substrate surface was formed and the intended ZnO layer covering the underlayer without any cracks could not be formed.

(Comparative Example 4)

An attempt was made to form a ZnO layer in a manner similar to that of Example 1, except that substrate 3 (a substrate of Si wafer with a thermally-oxidized film formed thereon on which a ZnO layer is formed by sputtering) was used and the ZnO particle layer was not formed. In the present comparative example, ZnO was grown by a CBD method using the sputtered solid ZnO layer as the underlayer instead of a ZnO particle layer. The pH values of reaction solution X before and after the reaction were 5.43 and 6.23 respectively. Figure 13 shows SEM photographs of the substrate after the reaction. In the present comparative example, huge rod-like ZnO deposits were deposited and the intended ZnO layer could not be formed.

(Comparative Example 5)

An attempt was made to form a ZnO layer in a manner similar to that of Example 1, except that substrate 3 (a substrate of Si wafer with a thermally-oxidized film ($SiO_2$ layer) formed thereon on which a ZnO layer is formed by sputtering) was used and the ZnO particle layer was not formed. In the present comparative example, ZnO was grown by a CBD method using the solid $SiO_2$ layer as the underlayer instead of a ZnO particle layer. The pH values of reaction solution X before and after the reaction were 5.43 and 6.23 respectively. Figure 14 shows SEM photographs of the substrate after the reaction. In the present comparative example, huge rod-like ZnO deposits were deposited and the intended ZnO layer could not be formed.

(Comparative Example 6)

An attempt was made to form a ZnO layer in a manner similar to that of Example 1, except that substrate 5 (a glass substrate on which a zinc acetate dihydrate layer is formed) was used and the ZnO particle layer was not formed. In the present comparative example, ZnO was grown by a CBD method using the zinc acetate dihydrate layer as the underlayer instead of a ZnO particle layer. The pH values of reaction solution X before and after the reaction were 5.43 and 6.23 respectively. Figure 15 shows SEM photographs of the substrate after the reaction. In the present comparative example, huge rod-like ZnO deposits were deposited and the intended ZnO layer could not be formed.

Main manufacturing conditions and evaluation results are summarized in Tables 1 to 3.

Table 1

| | Example 1 | Example 2 | Example 3 |
|---|---|---|---|
| Substrate | Sub. 1 | Sub. 1 | Sub. 2 |
| Underlayer Composition | Glass | Glass | CIGS |
| With/Without Particle Layer | With | With | With |
| Dispersion Solution For ZnO Particle Layer | D/S A (Rod-Like Particles) | D/S B (Rod-Like Particles) | D/S B (Rod-Like Particles) |
| Reaction Solution For ZnO Growth by CBD | R/S X | R/S X | R/S X |
| CBD Reaction Temp. | 85°C | 85°C | 85°C |
| CBD Reaction Time | 24h | 24h | 6h |
| ZnO Structure Grown By CBD | Continuous Film | Continuous Film | Continuous Film |

Substrate 1: glass substrate
Substrate 2: anodized aluminum substrate with Mo on which a CIGS layer is formed
Substrate 3: substrate of Si wafer with a thermally-oxidized film formed thereon on which a ZnO layer is formed by sputtering
Substrate 4: substrate of Si wafer on which a thermally-oxidized film is formed
Substrate 5: glass substrate on which a zinc acetate dihydrate layer is formed
Substrate 6: soda lime glass substrate (SLG) with Mo on which a CIGS layer is formed.
Reaction Solution X: zinc nitrate-dimethylamine borane (DMAB)
Reaction Solution Y: zinc sulfate-ammonium chloride-NaOH

Table 2

| | Example 4 | Example 5 | Example 6 |
|---|---|---|---|
| Substrate | Sub. 1 | Sub. 6 | Sub. 6 |
| Underlayer Composition | Glass | CIGS | CIGS |
| With/Without Particle Layer | With | With | With |
| Dispersion Solution For ZnO Particle Layer | D/S C (Mg:ZnO, Spherical Particles) | D/S D (Rod-Like Particles) | D/S D (Rod-Like Particles) |
| Reaction Solution For ZnO Growth by CBD | R/S X | R/S X | R/S X |
| CBD Reaction Temp. | 85°C | 85°C | 85°C |
| CBD Reaction Time | 24h | 24h | 6h |

(continued)

| | Example 4 | Example 5 | Example 6 |
|---|---|---|---|
| ZnO Structure Grown By CBD | Continuous Film | Continuous Film | Continuous Film |
| Substrate 1: glass substrate<br>Substrate 2: anodized aluminum substrate with Mo on which a CIGS layer is formed<br>Substrate 3: substrate of Si wafer with a thermally-oxidized film formed thereon on which a ZnO layer is formed by sputtering<br>Substrate 4: substrate of Si wafer on which a thermally-oxidized film is formed<br>Substrate 5: glass substrate on which a zinc acetate dihydrate layer is formed<br>Substrate 6: soda lime glass substrate (SLG) with Mo on which a CIGS layer is formed.<br>Reaction Solution X: zinc nitrate-dimethylamine borane (DMAB)<br>Reaction Solution Y: zinc sulfate-ammonium chloride-NaOH | | | |

Table 3

| | C/Eg. 1 | C/Eg. 2 | C/Eg. 3 | C/Eg. 4 | C/Eg. 5 | C/Eg. 6 |
|---|---|---|---|---|---|---|
| Substrate | Sub.1 | Sub.2 | Sub.1 | Sub.3 | Sub.4 | Sub.5 |
| Underlayer Composition | Glass | CIGS | Glass | ZnO (Sputterd Film) | $SiO_2$ | Zinc Acetate Dihydrate |
| With/Without Particle Layer | W/O | W/O | With | W/O | W/O | W/O |
| Dispersion Solution For ZnO Particle Layer | ----- | ----- | D/S B (Rod-Like Particles) | ----- | ----- | ----- |
| Reaction Solution For ZnO Growth by CBD | R/S X | R/S X | R/S Y | R/S X | R/S X | R/S X |
| CBD Reaction Temp. | 85°C | 85°C | 60°C | 85°C | 85°C | 85°C |
| CBD Reaction Time | 24h | 6h | 24h | 24h | 24h | 24h |
| ZnO Structure Grown By CBD | Huge Rod Deposit | Huge Rod Deposit | Nanowire Film | Huge Rod Deposit | Huge Rod Deposit | Huge Rod Deposit |
| Substrate 1: glass substrate<br>Substrate 2: anodized aluminum substrate with Mo on which a CIGS layer is formed<br>Substrate 3: substrate of Si wafer with a thermally-oxidized film formed thereon on which a ZnO layer is formed by sputtering<br>Substrate 4: substrate of Si wafer on which a thermally-oxidized film is formed<br>Substrate 5: glass substrate on which a zinc acetate dihydrate layer is formed<br>Substrate 6: soda lime glass substrate (SLG) with Mo on which a CIGS layer is formed.<br>Reaction Solution X: zinc nitrate-dimethylamine borane (DMAB)<br>Reaction Solution Y: zinc sulfate-ammonium chloride-NaOH | | | | | | |

(Bandgap Value Measurement)

In Example 2, the relationship between wavelength and diffuse reflectance was measured with respect to the glass substrate, ZnO particle layer/glass substrate (after formation of ZnO particle layer), and ZnO layer/ZnO particle layer/glass substrate (after formation of ZnO layer by the CBD method). Further, in Comparative Example 1 in which a particle layer was not formed, the relationship between wavelength and diffuse reflectance was measured with respect to ZnO deposits/glass substrate (after ZnO crystal growth by the CBD method). The measurement results are shown in Figure 16A.

Based on the data shown in Figure 16A, the relationship between photon energy and $(LnT)^2$ was obtained, the results of which are shown in Figure 16B. Then, as shown in Figure 16C, bandgap values were obtained by obtaining slopes of the rising portions of graphs of Figure 16B, the results of which were as follows:

ZnO particle layer/glass substrate of Example 2: 3.28 eV;
ZnO layer/ZnO particle layer/glass substrate of Example 2: 3.22 eV;

The difference in bandgap values between ZnO particle layer and ZnO layer: 0.06 ev; and ZnO deposits/glass substrate of Comparative Example 1: 3.14 eV.

It is known that the bandgap value of ZnO is about 3.2 to 3.4 eV, and reasonable results were obtained in Example 2. The reason for the small bandgap value of Comparative Example 1 is presumed that the amount of ZnO was small because huge rod-like deposits were generated and a film was not formed.

The layered film and the manufacturing method of the same may be applied preferably, for example, to photoelectric conversion devices used in solar cell apparatuses, infrared sensors, and the like.

## Claims

**1.** A layered film manufacturing method, comprising:

a process (A) for forming a particle layer of a plurality of one or more types of particles consisting mainly of a metal oxide and/or a metal hydroxide; and
a process (B) for forming, using a reaction solution which includes one or more types of metal ions, a metal oxide layer consisting mainly of an oxide of the one or more types of metal ions on the particle layer so as to cover the particle layer without any cracks by a liquid phase method under a pH condition in which at least a portion of the plurality of particles remains without being dissolved by the reaction solution,
whereby a layered film having a layered structure of the particle layer and the metal oxide layer is manufactured.

**2.** The layered film manufacturing method of claim 1, **characterized in that** the process (A) is performed by a method of applying a dispersion solution which includes the plurality of particles or a CBD (chemical bath deposition) method by which the plurality of particles is deposited.

**3.** The layered film manufacturing method of claim 1 or 2, **characterized in that** an average particle diameter of the plurality of particles forming the particle layer is 2 to 50 nm.

**4.** The layered film manufacturing method of any of claims 1 to 3, **characterized in that** an average crystallite diameter of the plurality of particles forming the particle layer is 2 to 50 nm.

**5.** The layered film manufacturing method of any of claims 1 to 4, **characterized in that** the metal oxide layer is formed by a CBD (chemical bath deposition) method in the process (B).

**6.** The layered film manufacturing method of any of claims 1 to 5, **characterized in that** the reaction solution used in the process (B) includes the one or more types of metal ions, a nitrate ion, and a reducing agent that reduces a nitrate ion to a nitrite ion.

**7.** The layered film manufacturing method of claim 6, **characterized in that** the process (B) includes a reaction process in which the one or more types of metal ions and a complex formed by the reducing agent coexist.

**8.** The layered film manufacturing method of claim 6 or 7, **characterized in that** the reaction solution used in the process (B) includes one or more types of amine borane compounds as the reducing agent.

**9.** The layered film manufacturing method of claim 8, **characterized in that** the reaction solution used in the process (B) includes dimethylamine borane as the reducing agent.

**10.** The layered film manufacturing method of any of claims 1 to 9, **characterized in that** the metal oxide layer is formed by keeping the pH of the reaction solution in the range from 3.0 to 8.0 from the start to the end of the reaction in the process (B).

**11.** The layered film manufacturing method of any of claims 1 to 10, **characterized in that** the layered film is a semiconductor film.

**12.** The layered film manufacturing method of claim 11, **characterized in that** the particle layer and the metal oxide layer are formed with a composition that causes the difference between a bandgap value of the metal oxide layer and a bandgap value of the particle layer to be 0 to 0.1.5 eV.

**13.** The layered film manufacturing method of claim 11 or 12, **characterized in that** a major component of the metal oxide layer is ZnO.

**14.** The layered film manufacturing method of any of claims 11 to 13, **characterized in that** a major component of the particle layer is ZnO.

**15.** The layered film manufacturing method of any of claims 1 to 14, **characterized in that** a particle layer which includes at least one type of rod-like particles, plate-like particles, and spherical particles is formed in the process (A) as the particle layer.

**16.** A method of manufacturing a photoelectric conversion device (1) having a layered structure of a lower electrode (20), a photoelectric conversion semiconductor layer (30) that generates a current by absorbing light, a buffer layer (40), a light transparent conductive layer (60), and an upper electrode (70) on a substrate (10),
**characterized in that** the buffer layer (40) and/or the light transparent conductive layer (60) is manufactured by the layered film manufacturing method of any of claims 1 to 15.

**17.** A method of manufacturing a photoelectric conversion device (1) having a layered structure of a lower electrode (20), a photoelectric conversion semiconductor layer (30) that generates a current by absorbing light, a buffer layer (40), a window layer (50), a light transparent conductive layer (60), and an upper electrode (70) on a substrate (10),
**characterized in that** at least one of the buffer layer (40), window layer (50), and light transparent conductive layer (60) is manufactured by the layered film manufacturing method of any of claims 1 to 15.

**18.** A layered film manufactured by the layered film manufacturing method of any of claims 1 to 15.

**19.** A layered film having a layered structure of a particle layer formed of a plurality of one or more types of particles consisting mainly of a metal oxide and/or a metal hydroxide, and a metal oxide layer consisting mainly of one or more types of metal oxides and covering the particle layer without any cracks.

**20.** The layered film of claim 19, **characterized in that** an average particle diameter of the plurality of particles forming the particle layer is 2 to 50 nm.

**21.** The layered film of claim 19 or 20, **characterized in that** an average crystallite diameter of the plurality of particles forming the particle layer is 2 to 50 nm.

**22.** The layered film of any of claims 19 to 21, **characterized in that** an average crystallite diameter of the metal oxide layer is not less than 100 nm.

**23.** The layered film of any of claims 19 to 22, **characterized in that** the layered film is a semiconductor film.

**24.** The layered film of claim 23, **characterized in that** the difference between a bandgap value of the metal oxide layer and a bandgap value of the particle layer is 0 to 0.15 eV.

**25.** The layered film of claim 23 or 24, **characterized in that** a major component of the metal oxide layer is ZnO.

**26.** The layered film of any of claims 23 to 25, **characterized in that** a major component of the particle layer is ZnO.

**27.** The layered film of any of claims 18 to 26, **characterized in that** the particle layer includes at least one type of rod-like particles, plate-like particles, and spherical particles.

**28.** The layered film of any of claims 18 to 27, **characterized in that** a film thickness of the particle layer is 2 nm to 1 μm and a film thickness of the metal oxide layer is 3 nm to 10 μm.

**29.** A photoelectric conversion device (1) having a layered structure of a lower electrode (20), a photoelectric conversion semiconductor layer (30) that generates a current by absorbing light, a buffer layer (40), a light transparent conductive layer (60), and an upper electrode (70) on a substrate (10),
**characterized in that** the buffer layer (40) and/or the light transparent conductive layer (60) is formed of the layered film of any of claims 18 to 28.

**30.** A photoelectric conversion device having a layered structure of a lower electrode (20), a photoelectric conversion semiconductor layer (30) that generates a current by absorbing light, a buffer layer (40), a window layer (50), a light transparent conductive layer (60), and an upper electrode (70) on a substrate (10),
**characterized in that** at least one of the buffer layer (40), window layer (50), and light transparent conductive layer (60) is the layered film of any of claims 18 to 28.

**31.** The photoelectric conversion device of claim 29 or 30, **characterized in that** a major component of the photoelectric conversion layer (30) is at least one type of chalcopyrite compound semiconductor.

**32.** The photoelectric conversion device of claim 31, **characterized in that** the at least one type of chalcopyrite compound semiconductor is formed of a group Ib element, a group IIIb element, and a group VIb element.

**33.** The photoelectric conversion device of claim 32, **characterized in that**:

the group Ib element is at least one type of element selected from the group consisting of Cu and Ag;
the group IIIb element is at least one type of element selected from the group consisting of Al, Ga, and In; and
the group VIb element is at least one type of element selected from the group consisting of S, Se, and Te.

**34.** The photoelectric conversion device of any of claims 29 to 33, **characterized in that** the substrate (10) is one of the following:

an anodized substrate which includes an Al base (11) consisting mainly of Al and has an $Al_2O_3$-based anodized film (12) formed on at least one surface side of the Al base (11);
an anodized substrate which includes a composite base formed of an Fe material consisting mainly of Fe with an Al material consisting mainly of Al combined to at least one surface side of the Fe material and has an $Al_2O_3$-based anodized film formed on at least one surface side of the composite base; and
an anodized substrate which includes a base formed of an Fe material consisting mainly of Fe with an Al film consisting mainly of Al formed on at least one surface side of the Fe material and has an $Al_2O_3$-based anodized film formed on at least one surface side of the base.

**35.** A solar cell apparatus, comprising the photoelectric conversion device of any of claims 29 to 34.

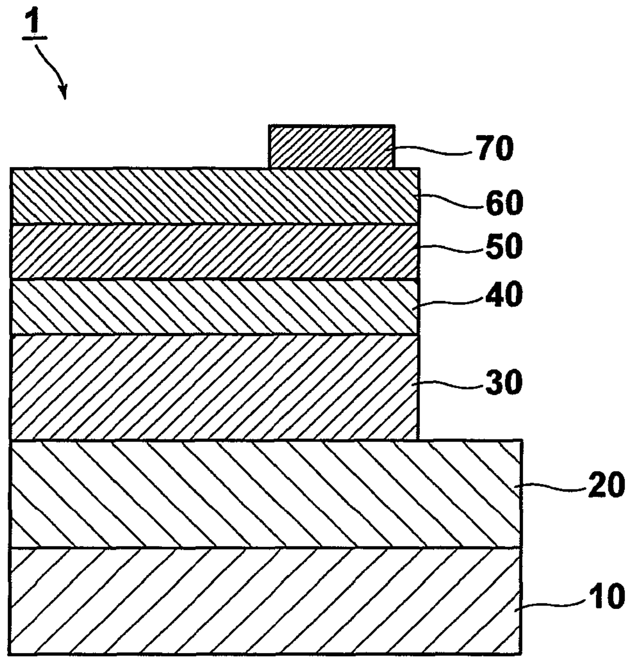


FIG.1

FIG.2

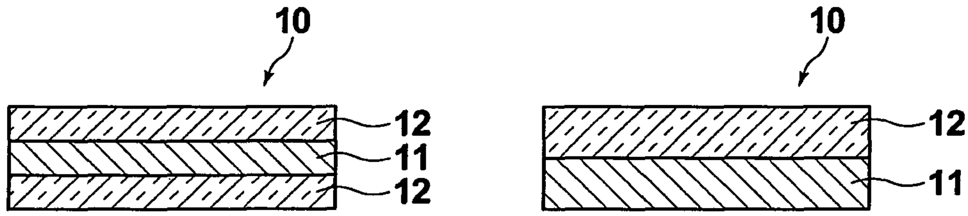

FIG.3

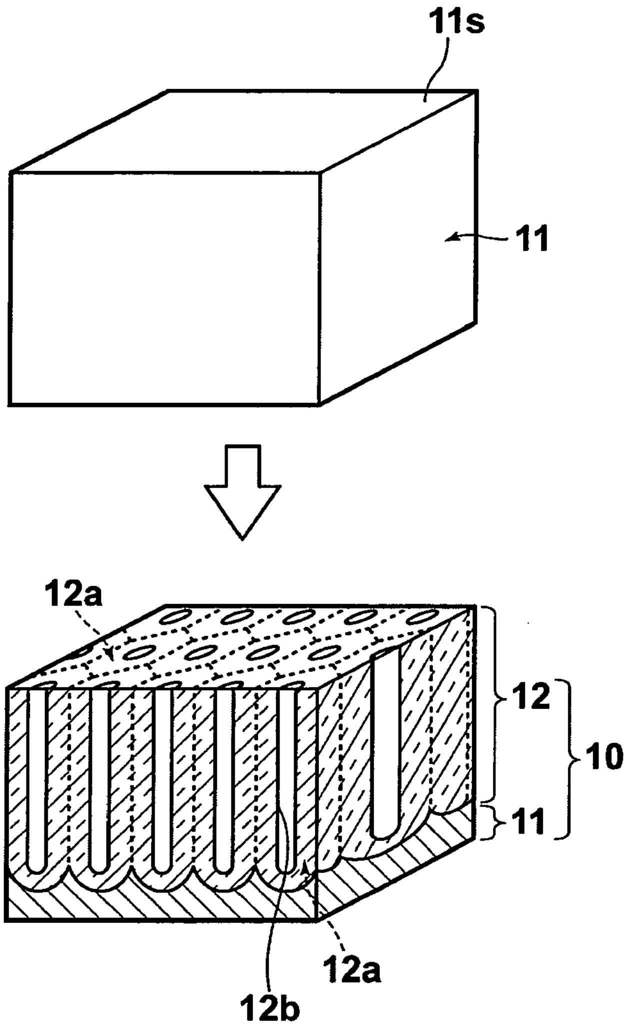

# FIG.4A

**ZnO PARTICLES IN DISPERSION SOLUTION A**

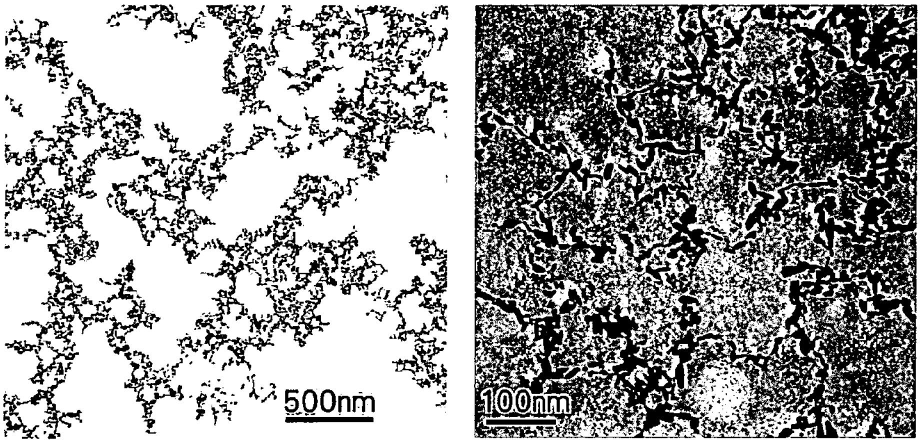


# FIG.4B

**ZnO PARTICLES IN DISPERSION SOLUTION B**

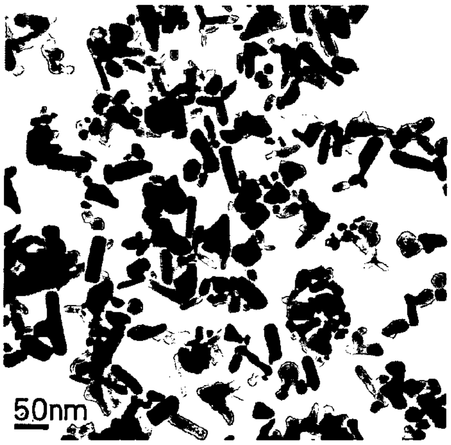


# FIG.4C

**Mg DOPED ZnO PARTICLES IN DISPERSION SOLUTION C**

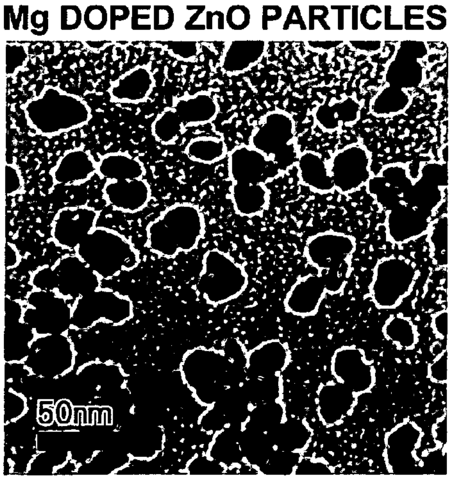

FIG.5
EXAMPLE 1

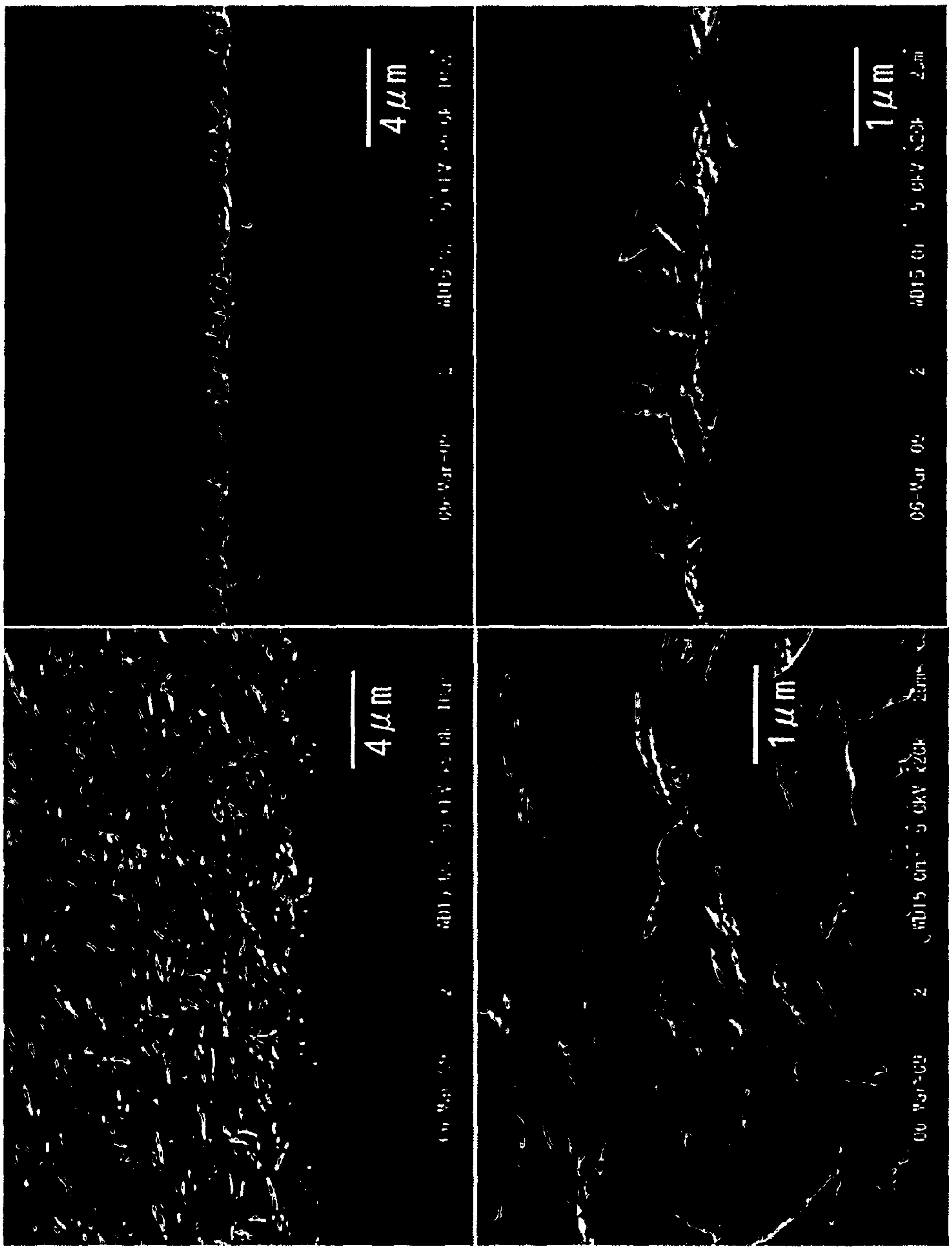

# FIG.6

EXAMPLE 2

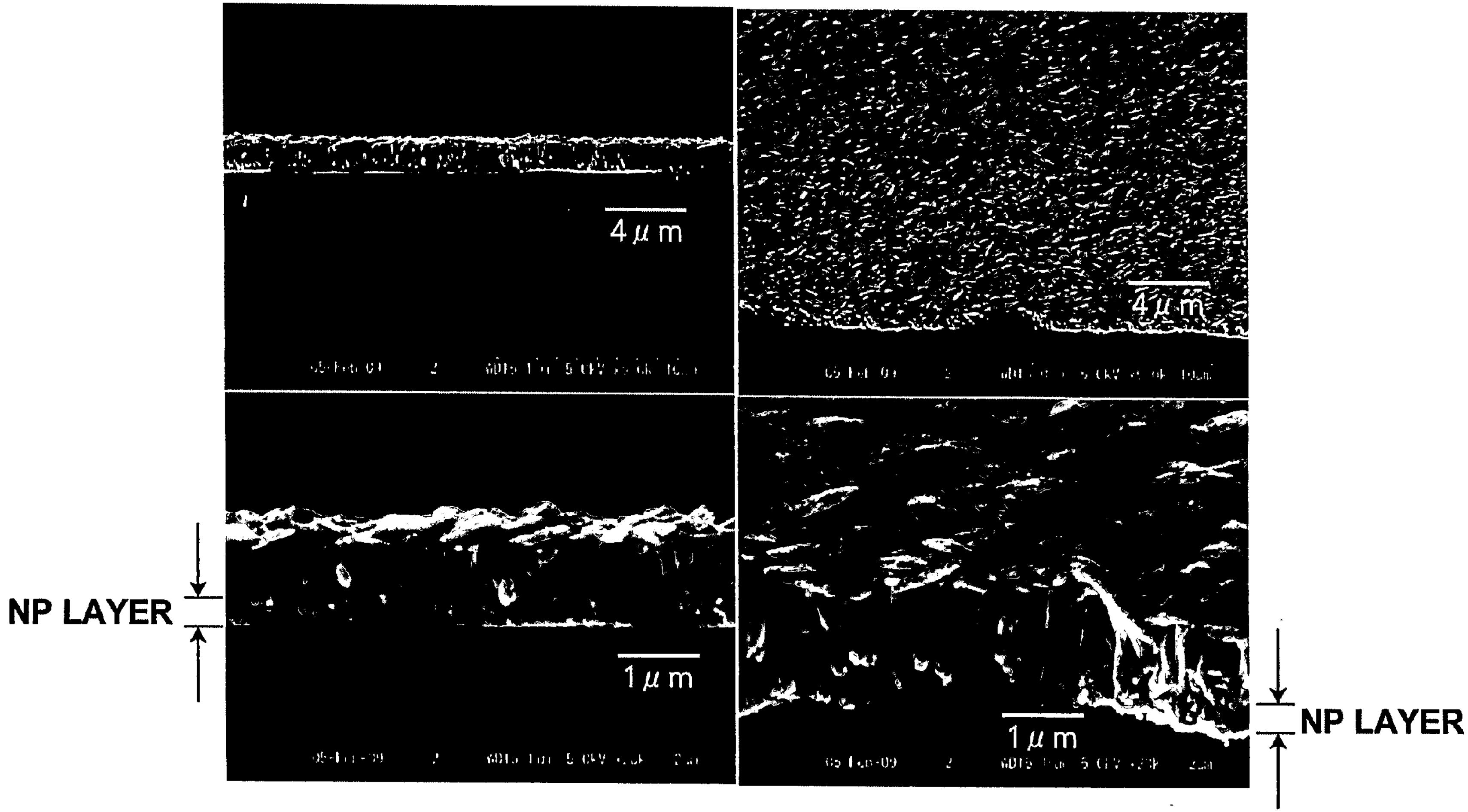

# FIG.7

**EXAMPLE 4**

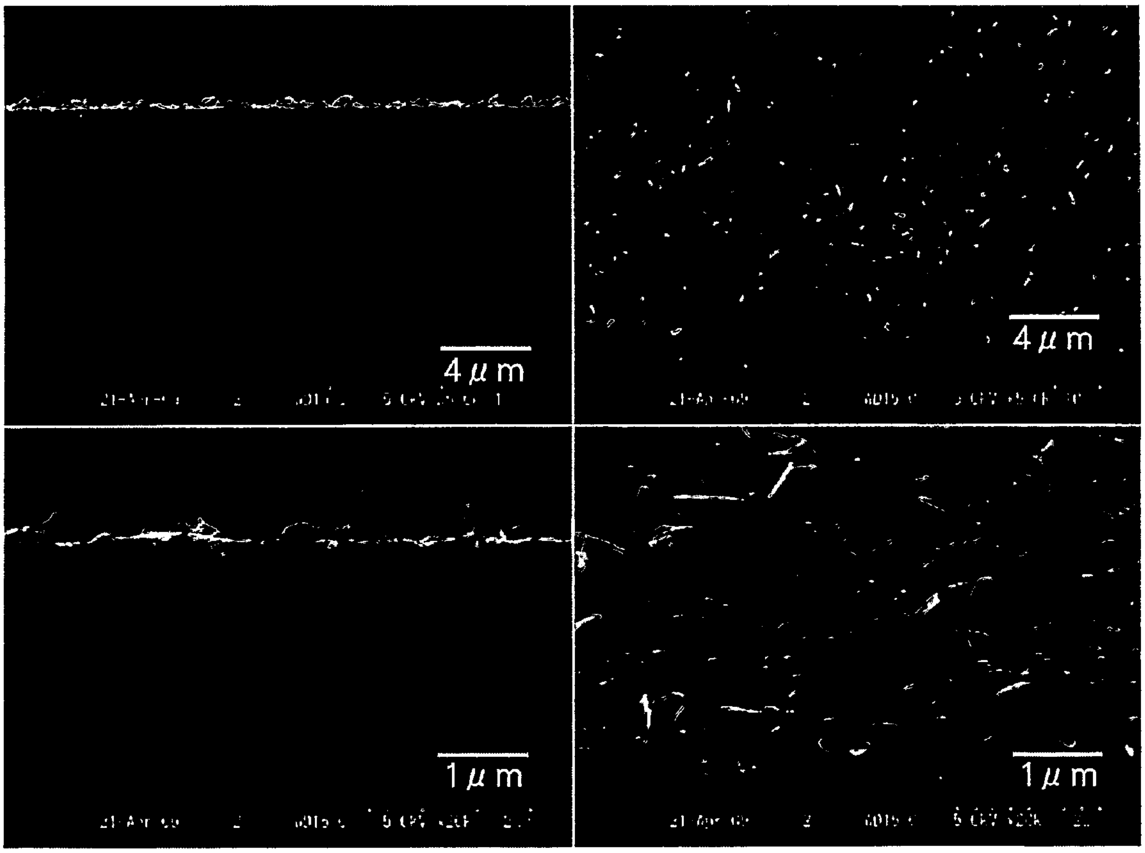

# FIG.8

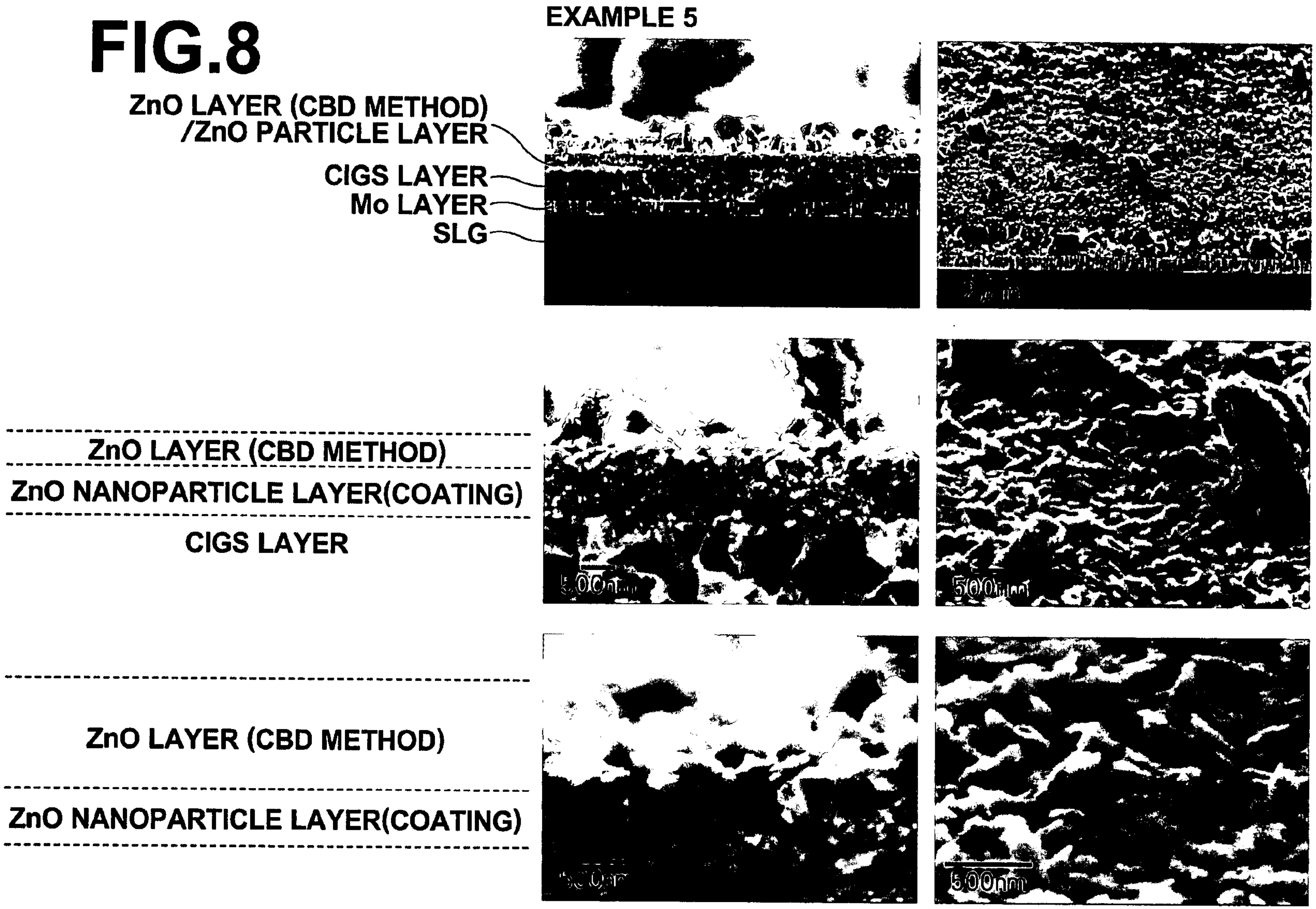
EXAMPLE 5
ZnO LAYER (CBD METHOD)
/ZnO PARTICLE LAYER
CIGS LAYER
Mo LAYER
SLG
ZnO LAYER (CBD METHOD)
ZnO NANOPARTICLE LAYER(COATING)
CIGS LAYER
ZnO LAYER (CBD METHOD)
ZnO NANOPARTICLE LAYER(COATING)
500nm
500nm
500nm

# FIG.9

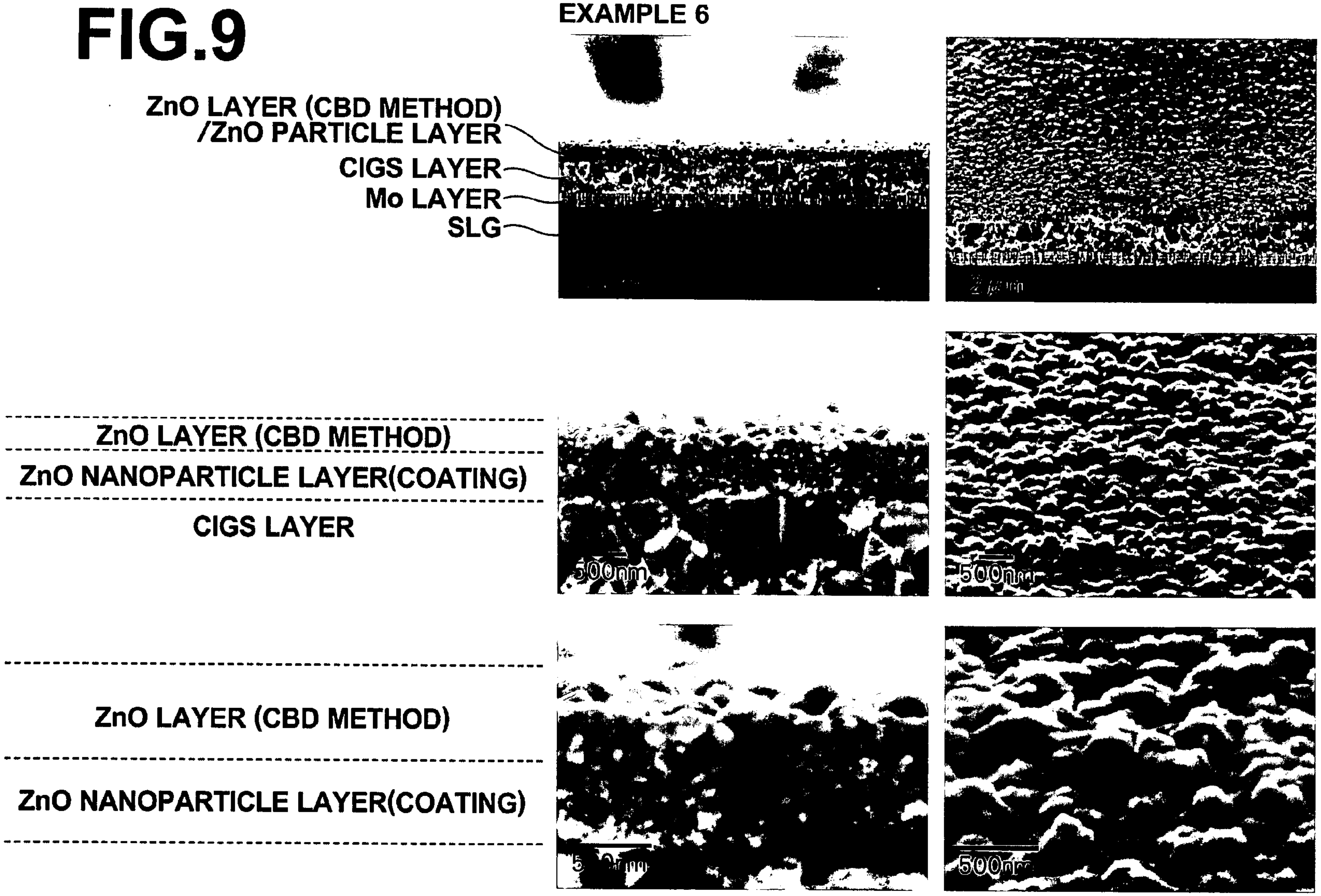
EXAMPLE 6
ZnO LAYER (CBD METHOD)
/ZnO PARTICLE LAYER
CIGS LAYER
Mo LAYER
SLG
2 μm
ZnO LAYER (CBD METHOD)
ZnO NANOPARTICLE LAYER(COATING)
CIGS LAYER
500nm
500nm
ZnO LAYER (CBD METHOD)
ZnO NANOPARTICLE LAYER(COATING)
500nm

# FIG.10

COMPARATIVE EXAMPLE 1

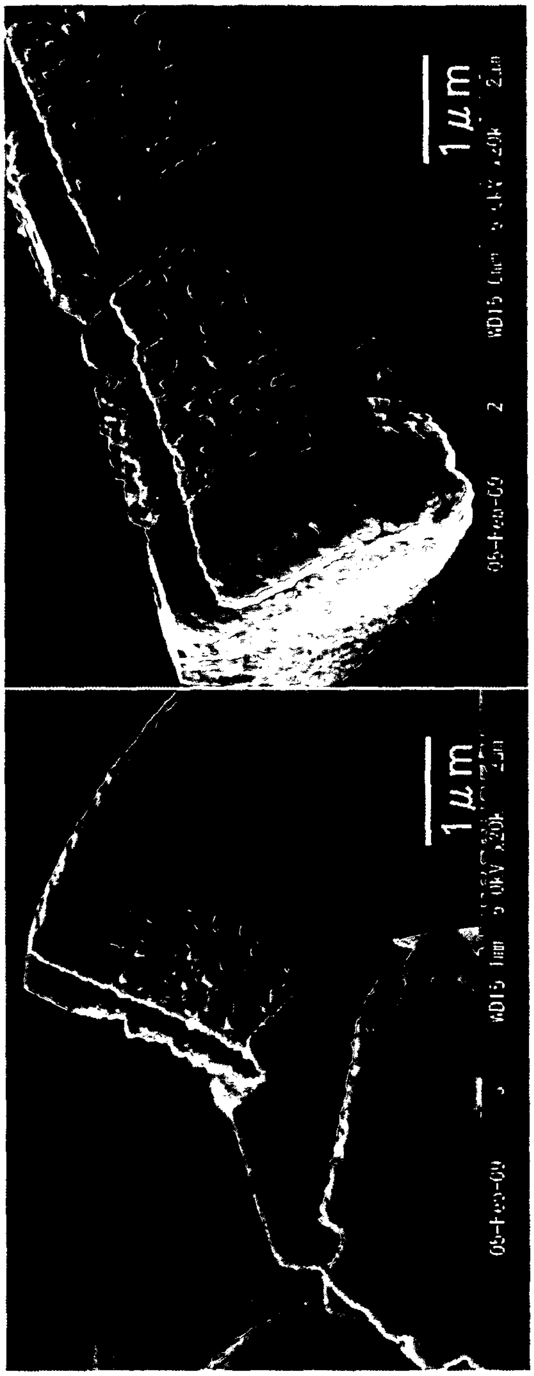

# FIG.11

COMPARATIVE EXAMPLE 2

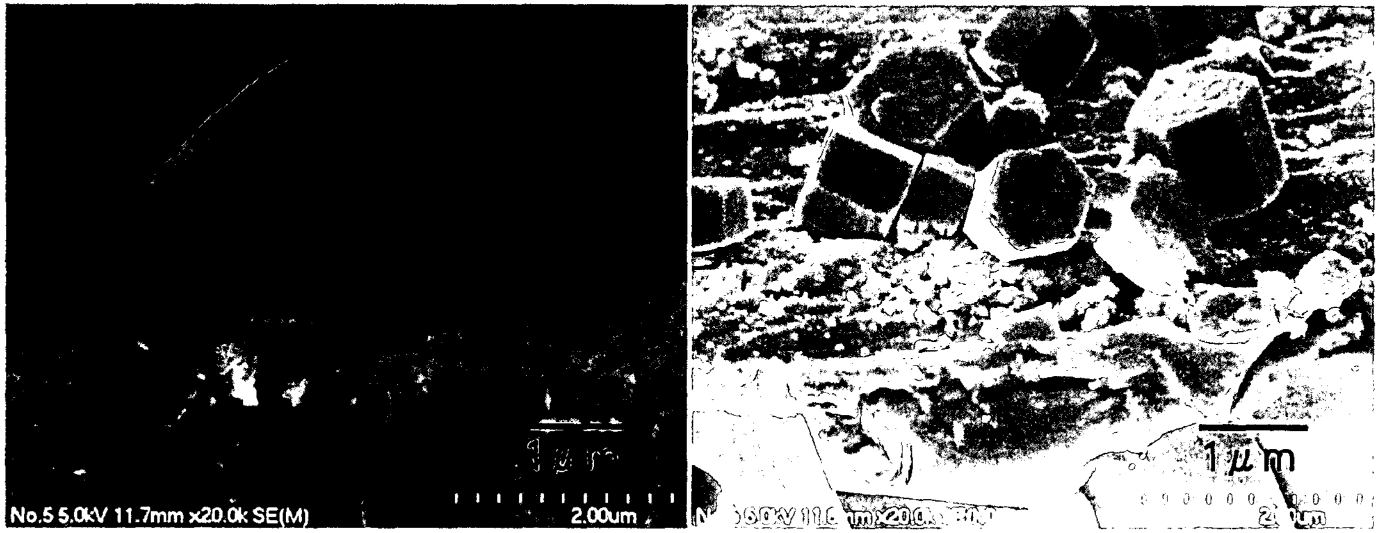

# FIG.12

COMPARATIVE EXAMPLE 3

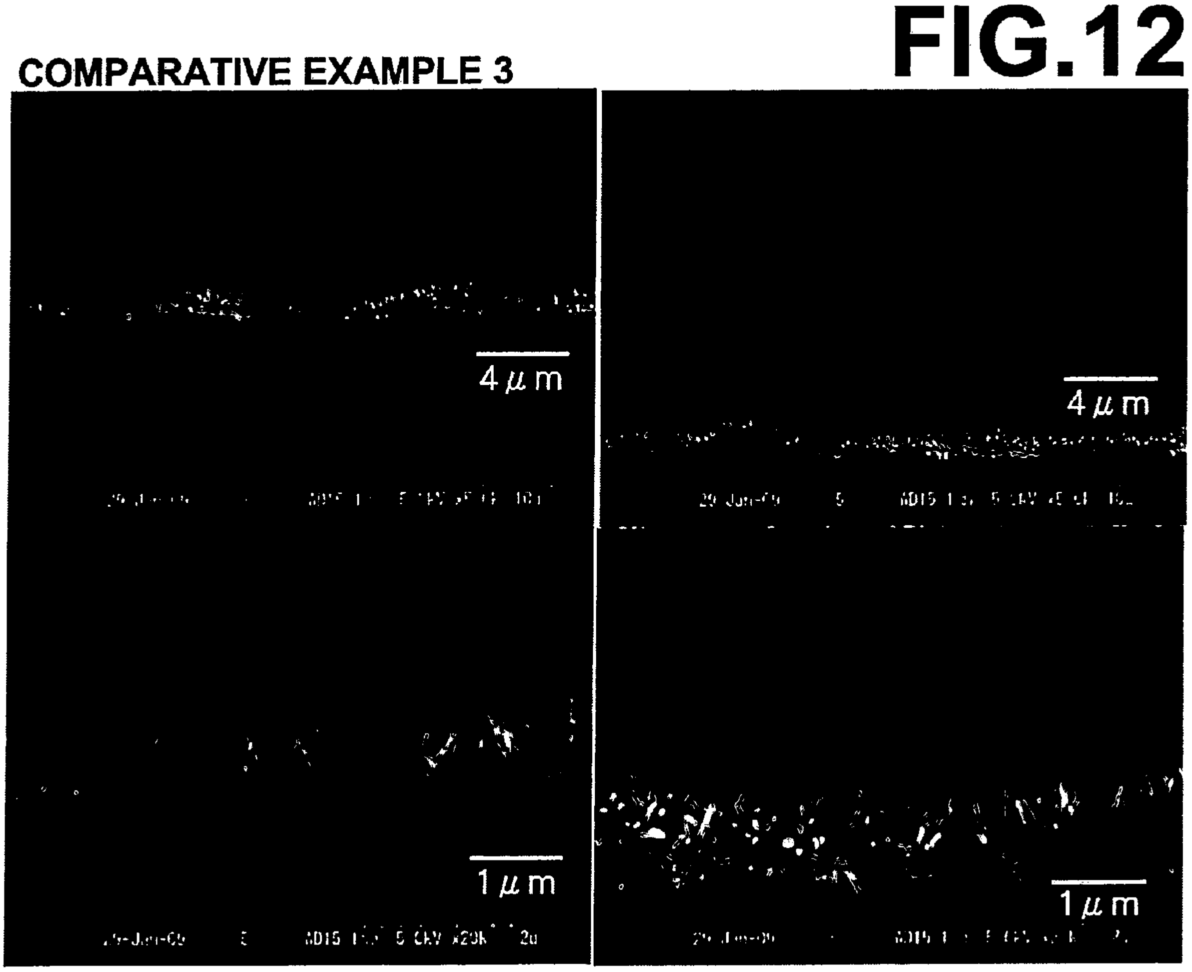

FIG.13

COMPARATIVE EXAMPLE 4

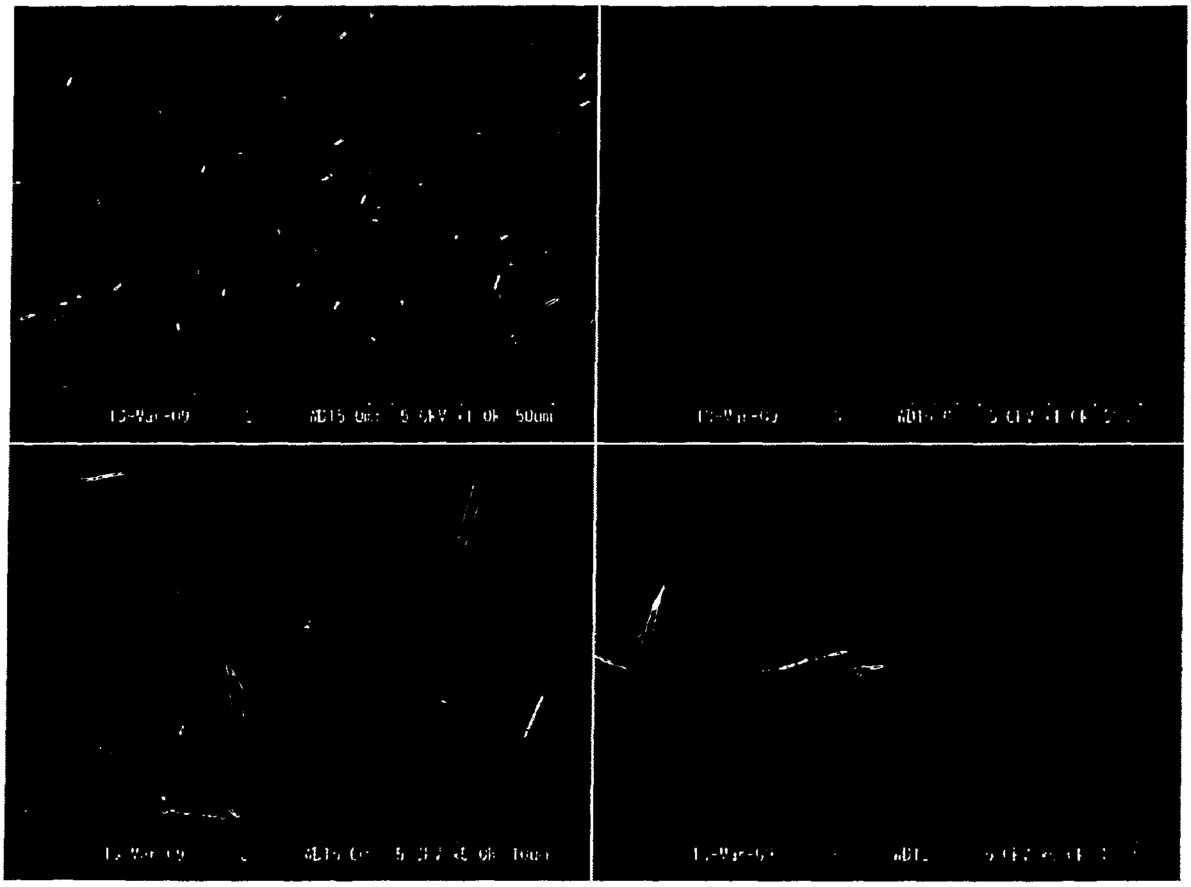

FIG.14

COMPARATIVE EXAMPLE 5

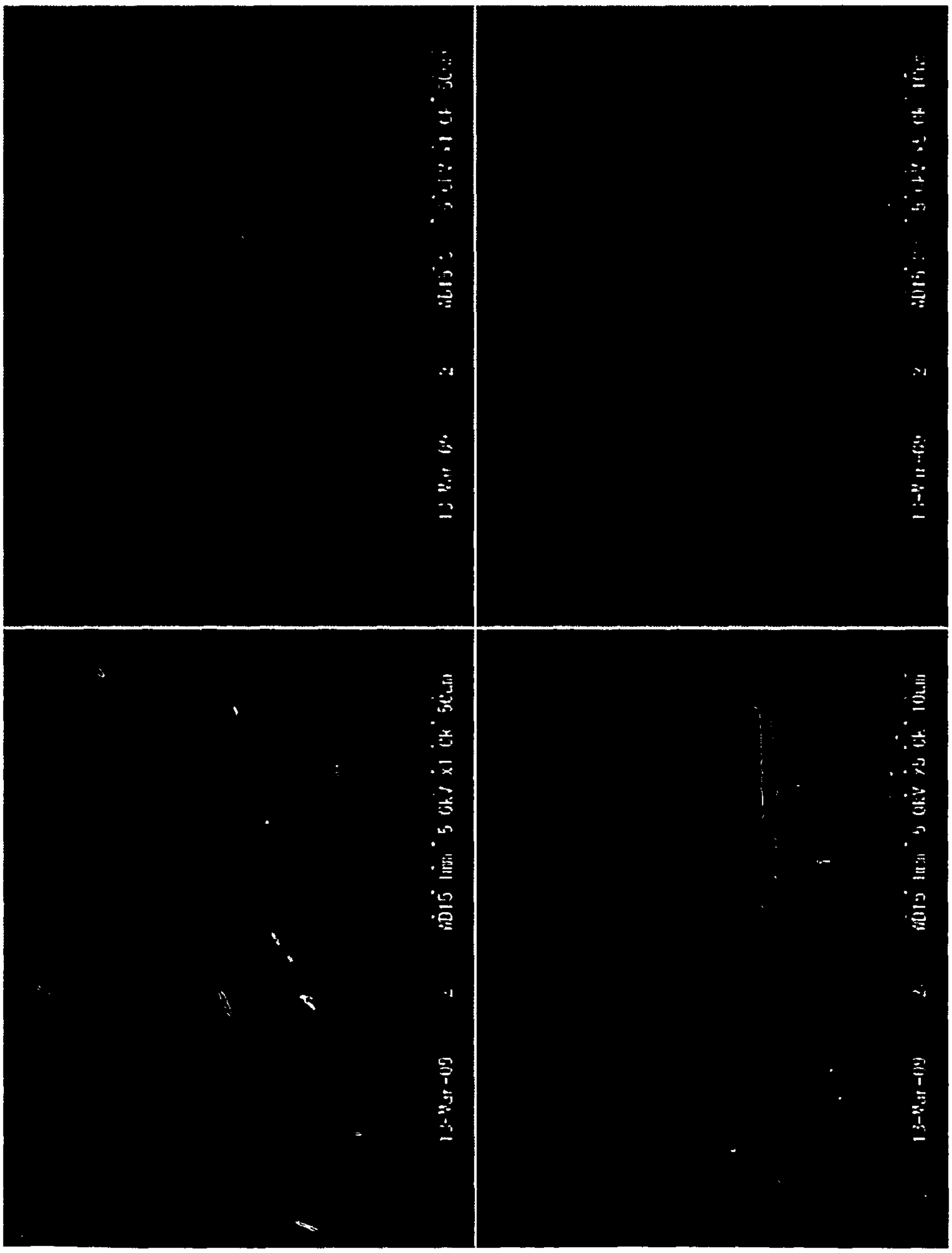

# FIG.15

COMPARATIVE EXAMPLE 6

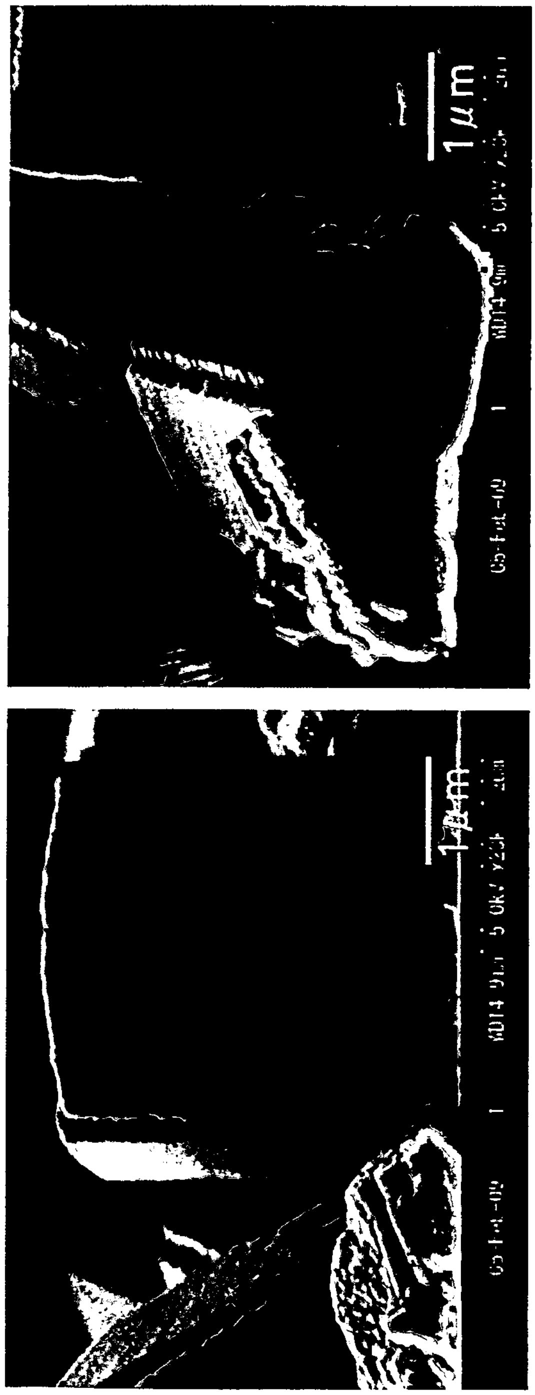

# FIG.16A

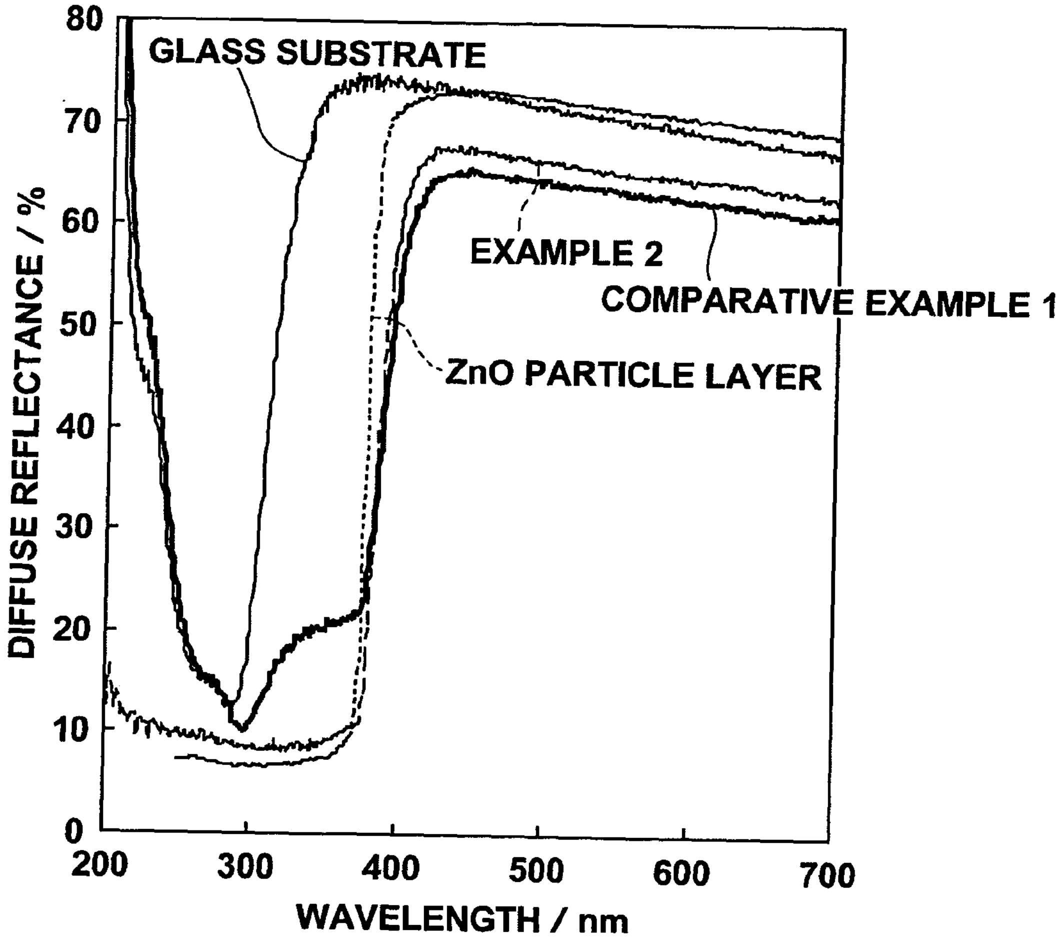

80
70
60
50
40
30
20
10
0
DIFFUSE REFLECTANCE / %
GLASS SUBSTRATE
EXAMPLE 2
COMPARATIVE EXAMPLE 1
ZnO PARTICLE LAYER
200
300
400
500
600
700
WAVELENGTH / nm

# FIG.16B

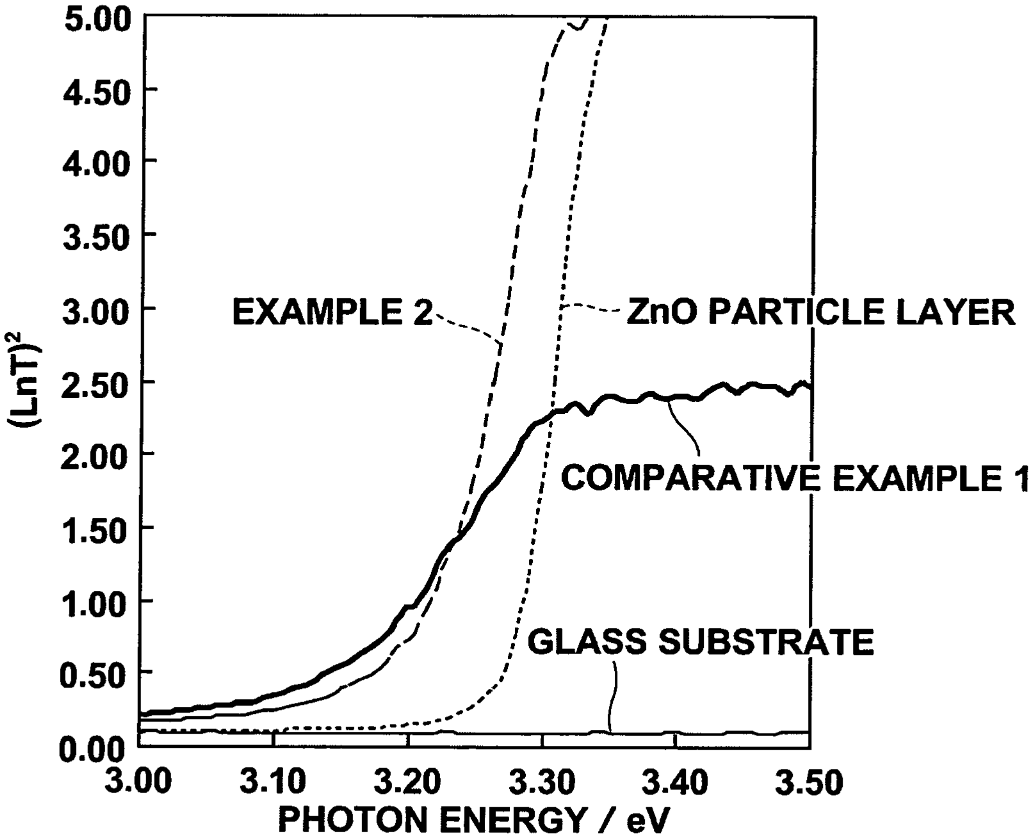
5.00
4.50
4.00
3.50
3.00
2.50
2.00
1.50
1.00
0.50
0.00
$(LnT)^2$
EXAMPLE 2
ZnO PARTICLE LAYER
COMPARATIVE EXAMPLE 1
GLASS SUBSTRATE
3.00
3.10
3.20
3.30
3.40
3.50
PHOTON ENERGY / eV

# FIG.16C

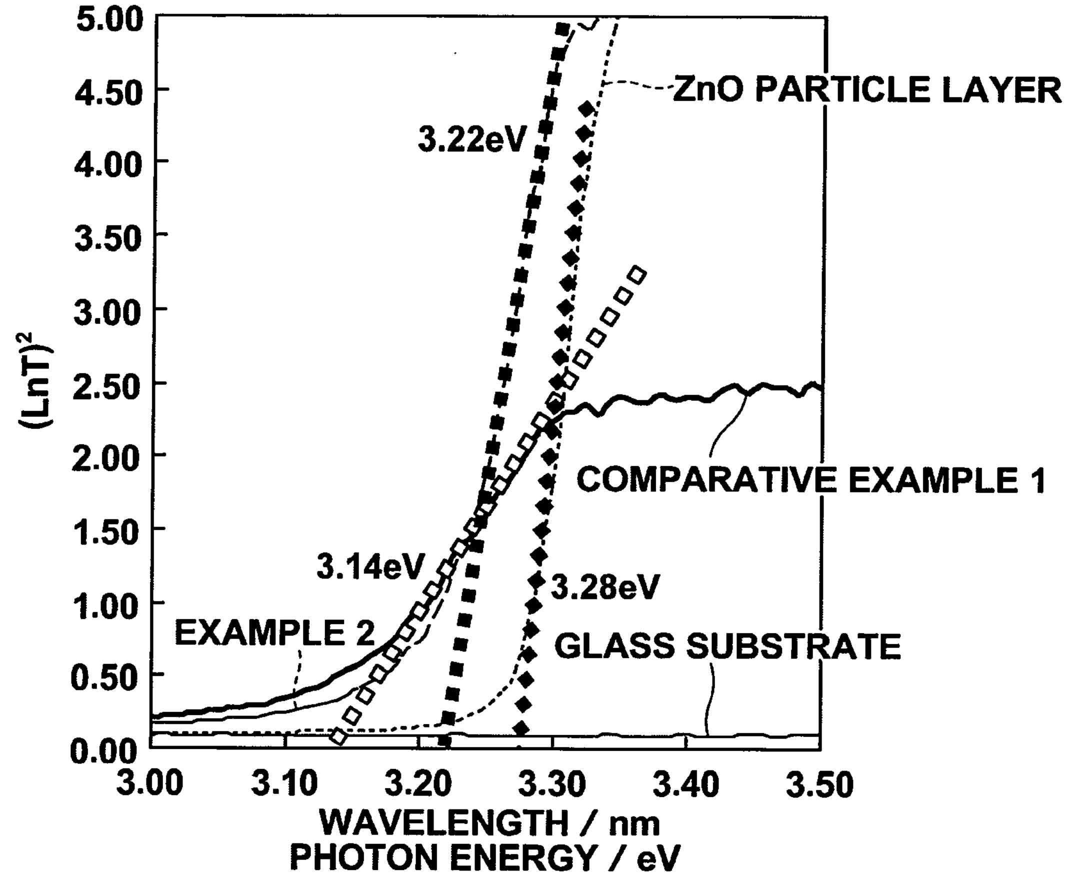
5.00
4.50
4.00
3.50
3.00
2.50
2.00
1.50
1.00
0.50
0.00
$(LnT)^2$
3.00
3.10
3.20
3.30
3.40
3.50
WAVELENGTH / nm
PHOTON ENERGY / eV
ZnO PARTICLE LAYER
3.22eV
COMPARATIVE EXAMPLE 1
3.14eV
3.28eV
EXAMPLE 2
GLASS SUBSTRATE

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 3256776 B
- JP 4081625 B
- JP 2004006790 A
- JP 2002170429 A
- JP 2004346383 A
- JP 2007242646 A
- JP 2000349320 A


### Non-patent literature cited in the description


- **M. Izaki ; T. Omi.** Transparent Zinc Oxide Films Chemically Prepared from Aqueous Solution. *Journal of The Electrochemical Society,* 1997, vol. 144 (1), L3-L4
- **H. Ishizaki et al.** Influence of (CH3)2NHBH3 Concentration on Electrical Properties of Electrochemically Grown ZnO Films. *Journal of The Electrochemical Society,* 2001, vol. 148 (8), C540-C543
- **L.E. Greene et al.** General Route to Vertical ZnO Nanowire Arrays Using Textured ZnO Seeds. *Nano Letters,* 2005, vol. 5 (7), 1231-1236
- **G. Hodes.** Semiconductor and ceramic nanoparticle films deposited by chemical bath deposition. *Physical Chemistry Chemical Physics,* 2007, vol. 9, 2181-2196
- **L.P. Bauermann.** Heterogeneous Nucleation of ZnO Using Gelatin as the Organic Matrix. *Chemistry of Materials,* 2006, vol. 18 (8), 2016-2020
- **S. Yamabi ; H. Imai.** Growth conditions for wurtzite zinc oxide films in aqueous solutions. *Journal of Materials Chemistry,* 2002, vol. 12, 3773-3778
- **X. Hu et al.** In situ forced hydrolysis-assisted fabrication and photo-induced electrical property in sensor of ZnO nanoarrays. *Journal of Colloid and Interface Science,* 2008, vol. 325, 459-463
- **X. Hu et al.** Micropatterning of ZnO Nanoarrays by Forced Hydrolysis of Anhydrous Zinc Acetate. *Langmuir,* 2008, vol. 24, 7614-7617